# EUROPÄISCHE PATENTSCHRIFT

(11) **EP 1 507 890 B1**
(45) Veröffentlichungstag und Bekanntmachung des Hinweises auf die Patenterteilung: **02.09.2015**
(21) Anmeldenummer: 03755077.9
(22) Anmeldetag: 09.05.2003
(51) Int. Cl.: C23C 16/455, C30B 25/14, C23C 14/56, C23C 16/04

(54) **VERFAHREN UND VORRICHTUNG ZUR PLASMABEHANDLUNG VON WERKSTÜCKEN**
METHOD AND DEVICE FOR PLASMA TREATING WORKPIECES
PROCEDE ET DISPOSITIF POUR LE TRAITEMENT AU PLASMA DE PIECES

(30) Priorität: 24.05.2002 DE 10223288; 07.06.2002 DE 10225609
(43) Veröffentlichungstag der Anmeldung: 23.02.2005
(73) Patentinhaber: KHS Corpoplast GmbH, 22145 Hamburg (DE)
(72) Erfinder: LITZENBERG, Michael, 21502 Geesthacht (DE); LEWIN, Frank, 22889 Tangstedt (DE); MÜLLER, Hartwig, 22952 Lütjensee (DE); VOGEL, Klaus, 22885 Barsbüttel (DE); ARNOLD, Gregor, 55294 Bodenheim (DE); BEHLE, Stephan, 55239 Gau Odernheim (DE); LÜTTRINGHAUS-HENKEL, Andreas, 64289 Darmstadt (DE); BICKER, Matthias, 55126 Mainz (DE); KLEIN, Jürgen, 55127 Mainz (DE); WALTHER, Marten, 55270 Engelstadt (DE)
(74) Vertreter: Hausfeld, Norbert
(86) Internationale Anmeldenummer: PCT/DE2003/001505
(87) Internationale Veröffentlichungsnummer: WO 2003/100125

(56) Entgegenhaltungen:
- EP-A- 0 463 392
- EP-A- 1 010 773
- WO-A-00/58631
- WO-A-95/22413
- WO-A-99/17334
- DE-C- 924 065
- US-A- 4 545 328
- US-A- 5 324 361

## Beschreibung

Die Erfindung betrifft ein Verfahren zur Plasmabehandlung von Werkstücken, bei dem das Werkstück in eine zumindest teilweise evakuierbare Plasmakammer einer Behandlungsstation eingesetzt wird und bei dem das Werkstück innerhalb der Behandlungsstation von einem Halteelement positioniert wird, und bei dem zur gleichzeitigen Versorgung von mindestens zwei Kammern mit mindestens einem Betriebsmittel eine Strömung des Betriebsmittels mindestens einmal von einer Verzweigung in mindestens zwei Teilströme verzweigt wird sowie bei dem ein Innenraum eines hohlkörperartigen Werkstückes behandelt wird, wobei die mindestens eine Plasmastation von einem rotierenden Plasmarad von einer Eingabepositionierung in eine Ausgabepositionierung überführt wird, und wobei von einem Primärvakuumventil ein erster Unterdruck und von einem Sekundärvakuumventil ein relativ zum ersten Unterdruck niedrigerer zweiter Unterdruck zugeschaltet wird, wobei die Verzweigung im Bereich eines Kammersockels angeordnet wird.

Die Erfindung betrifft darüber hinaus eine Vorrichtung zur Plasmabehandlung von Werkstücken, die mindestens eine evakuierbare Plasmakammer zur Aufnahme der Werkstücke aufweist und bei der die Plasmakammer im Bereich einer Behandlungsstation angeordnet ist, sowie bei der die Plasmakammer von einem Kammerboden, einem Kammerdeckel sowie einer seitlichen Kammerwandung begrenzt ist und mindestens ein Halteelement zur Positionierung des Werkstückes aufweist, und bei der mindestens zwei Plasmakammern an mindestens eine Verzweigung zur Aufteilung einer Strömung eines Betriebsmittels in mindestens zwei Teilströmungen angeschlossen sind, sowie bei der die Plasmastation zur Beschichtung eines Innenraumes eines hohlkörperartigen Werkstückes ausgebildet und die mindestens eine Plasmastation von einem rotierenden Plasmarad getragen ist, wobei mindestens eine Verzweigung an ein Primärvakuumventil zur Zuschaltung eines ersten Unterdruckes angeschlossen ist und wobei mindestens eine Verzweigung an ein Sekundärvakuumventil zur Zuschaltung eines relativ zum ersten Unterdruck niedrigeren Unterdruckes angeschlossen ist und mindestens eine Verzweigung im Bereich eines Kammersockels der Plasmastation angeordnet ist.

Derartige Verfahren und Vorrichtungen werden beispielsweise eingesetzt, um Kunststoffe mit Oberflächenbeschichtungen zu versehen. Insbesondere sind auch bereits Verfahren und Vorrichtungen bekannt, um innere oder äußere Oberflächen von Behältern zu beschichten, die zur Verpackung von Flüssigkeiten vorgesehen sind. Darüber hinaus sind Einrichtungen zur Plasmasterilisation bekannt.

In der PCT-WO 95/22413 wird eine Plasmakammer zur Innenbeschichtung von Flaschen aus PET beschrieben. Die zu beschichtenden Flaschen werden durch einen beweglichen Boden in eine Plasmakammer hineingehoben und im Bereich einer Flaschenmündung mit einem Adapter in Verbindung gebracht. Durch den Adapter hindurch kann eine Evakuierung des Flascheninnenraumes erfolgen. Darüber hinaus wird durch den Adapter hindurch eine hohle Lanze in den Innenraum der Flaschen eingeführt, um Prozeßgas zuzuführen. Eine Zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Flaschen je Zeiteinheit unterstützt.

In der EP-OS 10 10 773 wird eine Zuführeinrichtung erläutert, um einen Flascheninnenraum zu evakuieren und mit Prozeßgas zu versorgen. In der PCT-WO 01/31680 wird eine Plasmakammer beschrieben, in die die Flaschen von einem beweglichen Deckel eingeführt werden, der zuvor mit einem Mündungsbereich der Flaschen verbunden wurde.

Die PCT-WO 00/58631 zeigt ebenfalls bereits die Anordnung von Plasmastationen auf einem rotierenden Rad und beschreibt für eine derartige Anordnung eine gruppenweise Zuordnung von Unterdruckpumpen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kavität erwähnt.

Eine weitere Anordnung zur Durchführung einer Innenbeschichtung von Flaschen wird in der PCT-WO 99/17334 beschrieben. Es wird hier insbesondere eine Anordnung eines Mikrowellengenerators oberhalb der Plasmakammer sowie eine Vakuum- und Betriebsmittelzuleitung durch einen Boden der Plasmakammer hindurch beschrieben.

In der U.S. 5,324,361 A wird eine Beschichtung von Innenflächen von kalottenartigen Körpern beschrieben. Eine Verzweigung von Versorgungsleitungen erfolgt im Bereich einer externen Leitungsführung.

Die U.S. 4,545,328 A beschreibt ebenfalls eine stationäre Anordnung von Plasmastationen, bei denen Verzweigungen im Bereich einer Leitungsführung angeordnet sind.

Bei der überwiegenden Anzahl der bekannten Verfahren werden zur Verbesserung von Barriereeigenschaften des thermoplastischen Kunststoffmaterials durch das Plasma erzeugte Behälterschichten aus Siliziumoxiden mit der allgemeinen chemischen Formel SiOx verwendet. Zusätzlich können in den hierdurch erzeugten Barriereschichten auch Anteile von Kohlenstoff, Wasserstoff und Stickstoff enthalten sein. Derartige Barriereschichten verhindern ein Eindringen von Sauerstoff in die verpackten Flüssigkeiten sowie ein Austreten von Kohlendioxid bei CO₂-haltigen Flüssigkeiten.

Die bislang bekannten Verfahren und Vorrichtungen sind noch nicht in ausreichender weise dafür geeignet, für eine Massenproduktion eingesetzt zu werden, bei der sowohl ein geringer Beschichtungspreis je Werkstück als auch eine hohe Produktionsgeschwindigkeit erreicht werden muß.

Aufgabe der vorliegenden Erfindung ist es daher, ein Verfahren der einleitend genannten Art derart anzugeben, daß eine Betriebsmittelzuführung zur Behandlungsstation bei kompaktem Aufbau, kurzer Prozeßnebenzeiten und großer Zuverlässigkeit unterstützt wird.

Diese Aufgabe wird erfindungsgemäß dadurch gelöst, daß zum Einsetzen und Entnehmen des Werkstückes eine hülsenförmige Kammerwandung der Kammern hochgeschoben und anschließend abgesenkt wird.

Weitere Aufgabe der vorliegenden Erfindung ist es, eine Vorrichtung der einleitend genannten Art derart zu konstruieren, daß eine Betriebsmittelzuführung zur Plasmakammer bei kompaktem Aufbau unterstützt wird.

Diese Aufgabe wird erfindungsgemäß dadurch gelöst, daß die Kammerwandung hülsenförmig ausgebildet sowie hochschiebbar und absenkbar angeordnet ist.

Durch die gleichzeitige Versorgung mehrerer Kammern und durch die Verzweigung mindestens einer Betriebsmittelströmung wird eine sehr kompakte Baueinheit bereitgestellt, die eine räumlich dichte Anordnung mehrerer Plasmakammern nebeneinander unterstützt und die sowohl die Montage als auch spätere Servicearbeiten erleichtert. Darüber hinaus werden durch die Verzweigung sehr kurze Verbindungskanäle bereitgestellt, die zu einer Verkürzung der Prozeßnebenzeiten führen, da beispielsweise bei einer Vakuumzuführung auch die Anschlußkanäle evakuiert werden müssen, was zu einem entsprechenden Zeitaufwand führt.

### Weiter auf Seite 5 der Ursprungsunterlagen

Eine günstige Strömungsführung wird dadurch unterstützt, daß die Verzweigung in einer vertikalen Richtung durchgeführt wird.

Eine andere Variante besteht darin, daß die Verzweigung in einer horizontalen Richtung durchgeführt wird.

Bei einer Beschichtung von hohlen Werkstücken, die mit ihrer Mündung nach unten angeordnet sind, erweist es sich als vorteilhaft, daß eine Evakuierung einer Kavität der Plasmastation durch den Kammerboden hindurch erfolgt.

Eine gerätetechnisch einfache Realisierung wird ebenfalls dadurch unterstützt, daß durch den Kammerboden hindurch Prozeßgas zugeführt wird.

Eine schnelle und gleichmäßige Verteilung des Prozeßgases in einem Innenraum des Werkstückes kann dadurch erreicht werden, daß das Prozeßgas durch eine Lanze hindurch in einen Innenraum des Werkstückes zugeführt wird.

Zur Betriebsmittelversorgung eines das Werkstück umgebenden Raumes der Plasmakammer wird vorgeschlagen, daß mindestens ein Betriebsmittel von mindestens einer Verzweigung direkt in mindestens zwei Kammern eingeleitet wird.

Für eine Versorgung eines Innenraumes des Werkstückes wird vorgeschlagen, daß mindestens ein Betriebsmittel von mindestens einer Verzweigung in Innenräume von mindestens zwei Werkstücken eingeleitet wird.

Eine gezielte lokale Betriebsmitteleinbringung in den Innenraum des Werkstückes wird dadurch unterstützt, daß mindestens ein Betriebsmittel von mindestens einer Verzweigung in mindestens zwei Lanzen eingeleitet wird.

Bei sämtlichen Plasmaapplikationen erweist es sich als vorteilhaft, daß von der Verzweigung eine Unterdruckzuführung verteilt wird.

Bei einer Durchführung von Plasmabeschichtungen ist vorgesehen, daß von der Verzweigung eine Prozeßgaszuführung verteilt wird.

Eine einfache Beendigung eines jeweiligen Bearbeitungsvorganges wird dadurch unterstützt, daß von der Verzweigung eine Belüftungszuführung verteilt wird.

Zur Unterstützung einer steuerbaren Zündung des Plasmas wird vorgeschlagen, daß im Bereich des Kammerdeckels von einem Mikrowellengenerator erzeugte Mikrowellen in die Kavität eingeleitet werden.

Eine typische Anwendung besteht darin, daß ein Werkstück aus einem thermoplastischen Kunststoff behandelt wird.

Insbesondere ist daran gedacht daß ein Innenraum des Werkstückes behandelt wird.

Ein umfangreiches Anwendungsgebiet wird dadurch erschlossen, daß als Werkstück ein Behälter behandelt wird.

Insbesondere ist dabei daran gedacht, daß als Werkstück eine Getränkeflasche behandelt wird.

Eine hohe Produktionsrate bei großer Zuverlässigkeit und hoher Produktqualität kann dadurch erreicht werden, daß die mindestens eine Plasmastation von einem rotierenden Plasmarad von einer Eingabepositionierung in eine Ausgabepositionierung überführt wird.

Eine Vergrößerung der Produktionskapazität bei nur geringfügig gesteigertem gerätetechnischen Aufwand kann dadurch erreicht werden, daß von einer Plasmastation mehrere Kavitäten bereitgestellt werden.

Eine weitere konstruktive Vereinfachung wird dadurch unterstützt, daß von der Verzweigung eine Mikrowellenzuführung verteilt wird

Eine typische Anwendung wird dadurch definiert, daß als Plasmabehandlung eine Plasmabeschichtung durchgeführt wird.

Insbesondere ist daran gedacht, daß die Plasmabehandlung unter Verwendung eines Niederdruckplasmas durchgeführt wird.

Bei einer Beschichtung von Werkstücken aus Kunststoff erweist es sich als vorteilhaft, daß eine Plasmapolymerisation durchgeführt wird.

Eine gute Oberflächenhaftung wird dadurch unterstützt, daß durch das Plasma mindestens zum Teil organische Substanzen abgeschieden werden.

Besonders vorteilhafte Verwendungseigenschaften bei Werkstücken zur Verpackung von Lebensmitteln können dadurch erreicht werden, daß durch das Plasma mindestens zum Teil anorganische Substanzen abgeschieden werden.

Bei der Behandlung von Verpackungen ist insbesondere daran gedacht, daß durch das Plasma eine Substanz zur Verbesserung von Barriereeigenschaften des Werkstückes abgeschieden wird.

Zur Unterstützung einer hohen Gebrauchsqualität wird vorgeschlagen, daß zusätzlich ein Haftvermittler zur Verbesserung eines Anhaftens der Substanz auf einer Oberfläche des Werkstückes abgeschieden wird.

Eine hohe Produktivität kann dadurch unterstützt werden, daß in einer gemeinsamen Kavität mindestens zwei Werkstücke gleichzeitig behandelt werden.

Ein weiteres Anwendungsgebiet besteht darin, daß als Plasmabehandlung eine Plasmasterilisation durchgeführt wird.

Ebenfalls ist daran gedacht, daß als Plasmabehandlung eine Oberflächenaktivierung des Werkstückes durchgeführt wird.

Eine Verminderung des Aufwandes für eine Zündung des Plasmas kann dadurch erfolgen, daß mindestens eine Verzweigung an mindestens einen Mikrowellengenerator angeschlossen ist.

Eine wirkungsvolle Evakuierung der Plasmakammern wird dadurch unterstützt, daß mindestens eine Verzweigung an ein Primärvakuumventil zur Zuschaltung eines ersten Unterdrukkes angeschlossen ist.

Zur Vermeidung von Deformationen des Werkstückes wird vorgeschlagen daß das Primärvakuumventil mindestens zeitweilig sowohl einen Innenraum des Werkstückes als auch einen weiteren Innenraum der Plasmakammer an eine gemeinsame Unterdruckversorgung anschließt.

Für eine schnelle Evakuierung mit geringem Aufwand erweist es sich als vorteilhaft, daß mindestens eine Verzweigung an ein Sekundärvakuumventil zur Zuschaltung eines relativ zum ersten Unterdruck niedrigeren Unterdruckes angeschlossen ist.

Zur Erzeugung eines im Innenraum des Werkstückes relativ zur weiteren Plasmakammer niedrigeren Unterdruckes wird vorgeschlagen, daß das Sekundärvakuumventil mindestens zeitweilig ausschließlich einen Innenraum des Werkstückes mit der Unterdruckquelle verbindet.

Eine Deformation eines fertig behandelten Werkstückes wird ebenfalls dadurch vermieden, daß mindestens eine Verzweigung an ein Werkstückentlüftungsventil zur Verbindung eines Innenraumes des Werkstückes mit einem Umgebungsdruck angeschlossen ist.

Zur Unterstützung eines einfachen Öffnens der Plasmakammer wird vorgeschlagen, daß mindestens eine Verzweigung an ein Kammerentlüftungsventil zur Verbindung eines Innenraumes der Plasmakammer mit einem Umgebungsdruck angeschlossen ist.

Eine Prozeßgaszuführung wird dadurch unterstützt, daß mindestens eine Verzweigung an ein Primärprozeßgasventil angeschlossen ist.

Zur Ermöglichung einer zeitlich aufeinander folgenden Zuführung unterschiedlich zusammengesetzter Prozeßgase wird vorgeschlagen, daß mindestens eine Verzweigung an ein Sekundärprozeßgasventil angeschlossen ist.

Eine Unterdruckaufrechterhaltung während der Durchführung des Plasmabehandlungsvorganges wird dadurch unterstützt, daß mindestens eine Verzweigung an ein Prozeßvakuumventil angeschlossen ist.

Eine Abschottung eines Innenraumes des Werkstückes gegenüber einem weiteren Innenraum der Plasmakammer wird dadurch unterstützt, daß mindestens eine Verzweigung an ein Kammervakuumventil angeschlossen ist.

Eine kompakte Ausführungsform kann dadurch bereitgestellt werden, daß mindestens eine Verzweigung im Bereich eines Kammersockels der Plasmastation angeordnet ist.

Zur Unterstützung einer guten Zugänglichkeit ist insbesondere daran gedacht, daß mindestens eine Verzweigung in lotrechter Richtung unterhalb des Kammerbodens angeordnet ist.

Eine sehr kompakte Konstruktion kann dadurch bereitgestellt werden, daß mindestens eine Verzweigung mit dem Kammersokkel ein gemeinsames Bauteil ausbildet.

Ebenfalls trägt es zu einer kompakten Konstruktion bei, daß mindestens zwei der Ventile im Bereich eines gemeinsamen Ventilblockes angeordnet sind.

Eine sehr raumsparende Konstruktion kann dadurch erreicht werden, daß mindestens eine der Verzweigungen im Bereich des Ventilblockes angeordnet ist.

Insbesondere ist zur Unterstützung einer einfachen Montage sowie einer einfachen Durchführung von Servicearbeiten daran gedacht, daß der Ventilblock mit den mindestens zwei Ventilen und der mindestens einen Verzweigung in lotrechter Richtung unterhalb des Kammersockels angeordnet ist.

Eine nochmalige Steigerung der Kompaktheit kann dadurch erreicht werden, daß der Ventilblock mit mindestens einer Verzweigung ein gemeinsames Bauteil ausbildet.

Eine an unterschiedliche Anwendungsanforderungen anpaßbare Ansteuerung wird dadurch bereitgestellt, daß mindestens eines der Ventile als ein elektromagnetisch gesteuertes Ventil ausgebildet ist:

In den Zeichnungen sind Ausführungsbeispiele der Erfindung schematisch dargestellt. Es zeigen:
- Fig. 1: Eine Prinzipskizze einer Mehrzahl von Plasmakammern, die auf einem rotierenden Plasmarad angeordnet sind und bei der das Plasmarad mit Eingabe- und Ausgaberädern gekoppelt ist.
- Fig. 2: eine Anordnung ähnlich zu Fig. 1, bei der die Plasmastation jeweils mit zwei Plasmakammern ausgestattet sind,
- Fig. 3: eine perspektivische Darstellung eines Plasmarades mit einer Vielzahl von Plasmakammern,
- Fig. 4: eine perspektivische Darstellung einer Plasmastation mit einer Kavität,
- Fig. 5: eine Vorderansicht der Vorrichtung gemäß Fig. 4 mit geschlossener Plasmakammer,
- Fig. 6: einen Querschnitt gemäß Schnittlinie VI-VI in Fig. 5,
- Fig. 7: eine Darstellung entsprechend Fig. 5 mit geöffneter Plasmakammer,
- Fig. 8: einen Vertikalschnitt gemäß Schnittlinie VIII-VIII in Fig. 7,
- Fig. 9: eine vergrößerte Darstellung der Plasmakammer mit zu beschichtender Flasche gemäß Fig. 6,
- Fig. 10: eine nochmals vergrößerte Darstellung eines Anschlußelementes zur Halterung des Werkstückes in der Plasmakammer,
- Fig. 11: eine schematische Darstellung einer Positionierung eines flaschenförmigen Werkstückes innerhalb der Plasmakammer unter Verwendung eines zangenartigen Halteelementes,
- Fig. 12: einen Vertikalschnitt durch eine Plasmastation mit zwei Plasmakammern, die über eine kanalartige Verzweigung an eine gemeinsame Betriebsmittelzuführung angeschlossen sind,
- Fig. 13: einen Vertikalschnitt gemäß Schnittlinie XIII-XIII in Fig. 12 und
- Fig. 14: eine schematische Darstellung für einen Anschluß eines mit sich verzweigenden Anschlußkanälen versehenen Kammersockels an eine Mehrzahl von Ventilen.

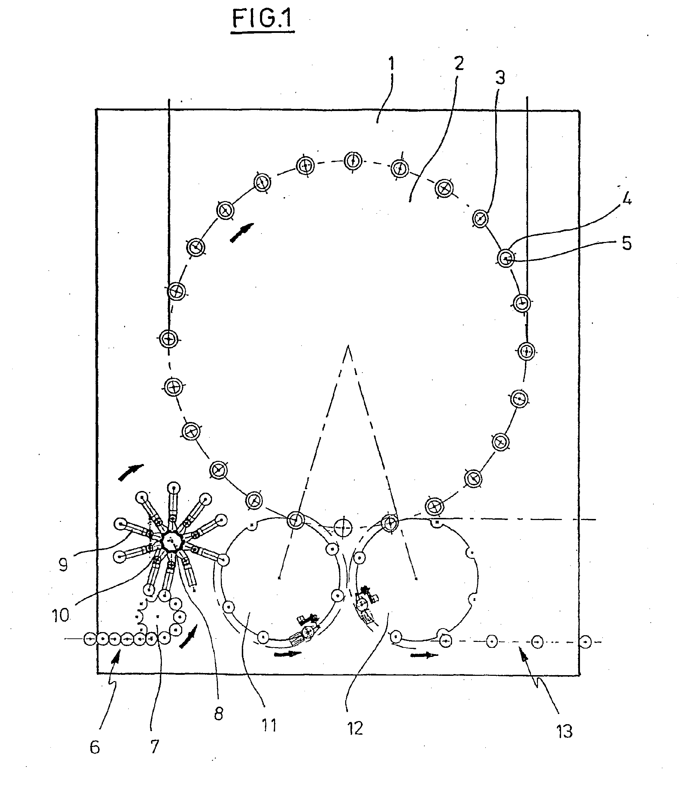

Aus der Darstellung in Fig. 1 ist ein Plasmamodul (1) zu erkennen, das mit einem rotierenden Plasmarad (2) versehen ist. Entlang eines Umfanges des Plasmarades (2) sind eine Mehrzahl von Plasmastationen (3) angeordnet. Die Plasmastationen (3) sind mit Kavitäten (4) bzw. Plasmakammern (17) zur Aufnahme von zu behandelnden Werkstücken (5) versehen.

Die zu behandelnden Werkstücke (5) werden dem Plasmamodul (1) im Bereich einer Eingabe (6) zugeführt und über ein Vereinzelungsrad (7) an ein Übergaberad (8) weitergeleitet, das mit positionierbaren Tragarmen (9) ausgestattet ist. Die Tragarme (9) sind relativ zu einem Sockel (10) des Übergaberades (8) verschwenkbar angeordnet, so daß eine Abstandsveränderung der Werkstücke (5) relativ zueinander durchgeführt werden kann. Hierdurch erfolgt eine Übergabe der Werkstücke (5) vom Übergaberad (8) an ein Eingaberad (11) mit einem relativ zum Vereinzelungsrad (7) vergrößerten Abstand der Werkstücke (5) relativ zueinander. Das Eingaberad (11) übergibt die zu behandelnden Werkstücke (5) an das Plasmarad (2). Nach einer Durchführung der Behandlung werden die behandelten Werkstücke (5) von einem Ausgaberad (12) aus dem Bereich des Plasmarades (2) entfernt und in den Bereich einer Ausgabestrecke (13) überführt.

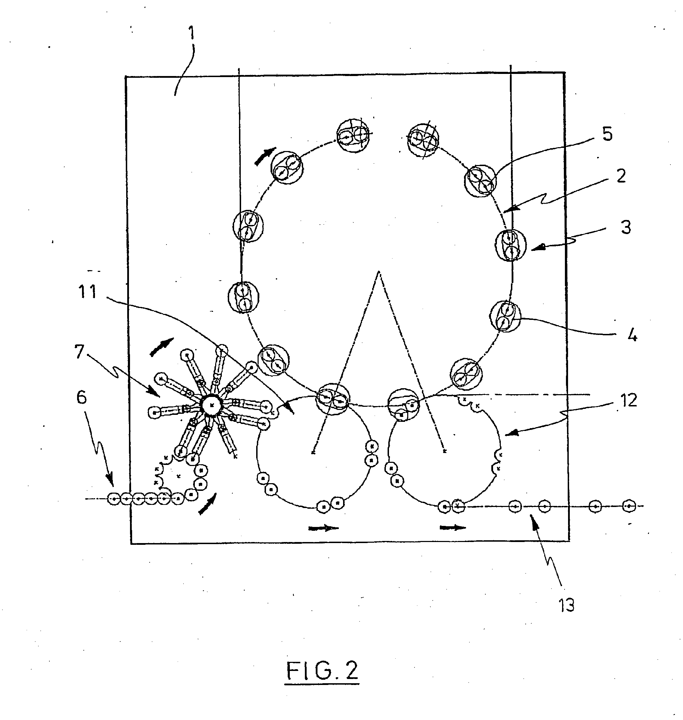

Bei der Ausführungsform gemäß Fig. 2 sind die Plasmastationen (3) jeweils mit zwei Kavitäten (4) bzw. Plasmakammern (17) ausgestattet. Hierdurch können jeweils zwei Werkstücke (5) gleichzeitig behandelt werden. Grundsätzlich ist es hierbei möglich, die Kavitäten (4) vollständig voneinander getrennt auszubilden, grundsätzlich ist es aber auch möglich, in einem gemeinsamen Kavitätenraum lediglich Teilbereiche derart gegeneinander abzugrenzen, daß eine optimale Beschichtung aller Werkstücke (5) gewährleistet ist. Insbesondere ist hierbei daran gedacht, die Teilkavitäten zumindest durch separate Mikrowelleneinkopplungen gegeneinander abzugrenzen.

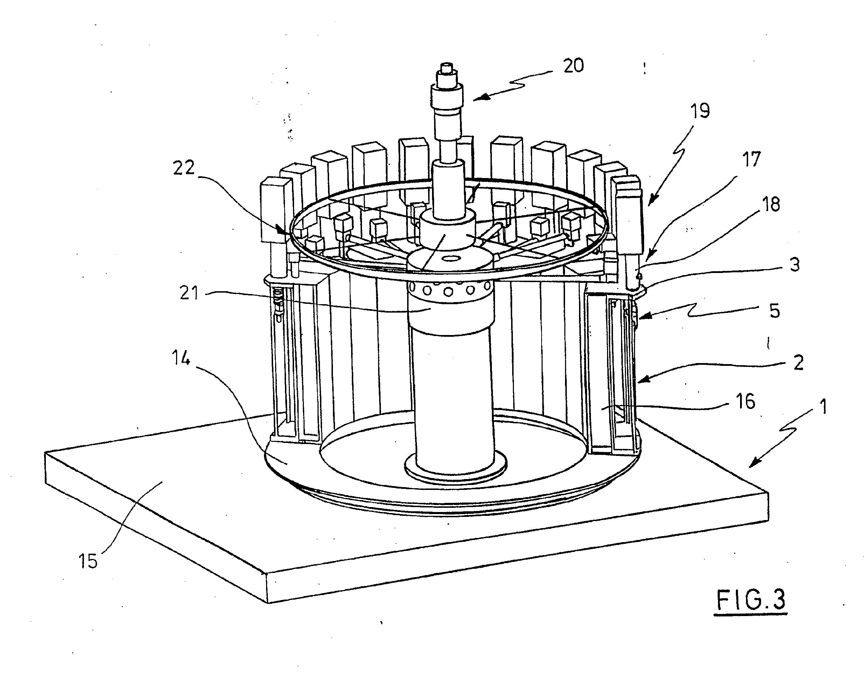

Fig. 3 zeigt eine perspektivische Darstellung eines Plasmamoduls (1) mit teilweise aufgebautem Plasmarad (2). Die Plasmastationen (3) sind auf einem Tragring (14) angeordnet, der als Teil einer Drehverbindung ausgebildet und im Bereich eines Maschinensockels (15) gelagert ist. Die Plasmastationen (3) weisen jeweils einen Stationsrahmen (16) auf, der Plasmakammern (17) haltert. Die Plasmakammern (17) weisen zylinderförmige Kammerwandungen (18) sowie Mikrowellengeneratoren (19) auf.

In einem Zentrum des Plasmarades (2) ist ein Drehverteiler (20) angeordnet, über den die Plasmastationen (3) mit Betriebsmitteln sowie Energie versorgt werden. Zur Betriebsmittelverteilung können insbesondere Ringleitungen (21) eingesetzt werden.

Die zu behandelnden Werkstücke (5) sind unterhalb der zylinderförmigen Kammerwandungen (18) dargestellt. Unterteile der Plasmakammern (17) sind zur Vereinfachung jeweils nicht eingezeichnet.

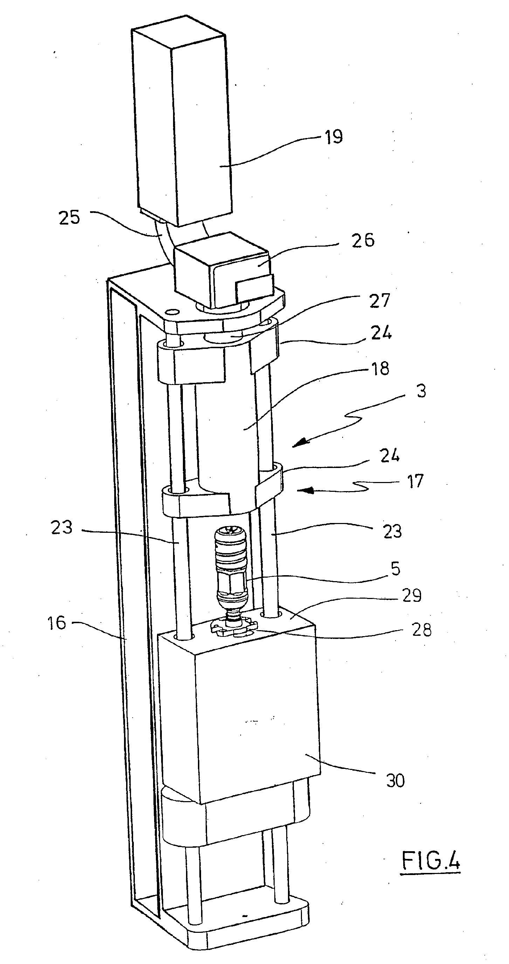

Fig. 4 zeigt eine Plasmastation (3) in perspektivischer Darstellung. Es ist zu erkennen, daß der Stationsrahmen (16) mit Führungsstangen (23) versehen ist, auf denen ein Schlitten (24) zur Halterung der zylinderförmigen Kammerwandung (18) geführt ist. Fig. 4 zeigt den Schlitten (24) mit Kammerwandung (18) in einem angehobenen Zustand, so daß das Werkstück (5) freigegeben ist.

Im oberen Bereich der Plasmastation (3) ist der Mikrowellengenerator (19) angeordnet. Der Mikrowellengenerator (19) ist über eine Umlenkung (25) und einen Adapter (26) an einen Kopplungskanal (27) angeschlossen, der in die Plasmakammer (17) einmündet. Grundsätzlich kann der Mikrowellengenerator (19) sowohl unmittelbar im Bereich des Kammerdekkels (31) als auch über ein Distanzelement an den Kammerdeckel (31) angekoppelt mit einer vorgebbaren Entfernung zum Kammerdeckel (31) und somit in einem größeren Umgebungsbereich des Kammerdeckels (31) angeordnet werden. Der Adapter (26) hat die Funktion eines Übergangselementes und der Kopplungskanal (27) ist als ein Koaxialleiter ausgebildet. Im Bereich einer Einmündung des Kopplungskanals (27) in den Kammerdeckel (31) ist ein Quarzglasfenster angeordnet. Die Umlenkung (25) ist als ein Hohlleiter ausgebildet.

Das Werkstück (5) wird im Bereich eines Dichtelementes (28) positioniert, das im Bereich eines Kammerbodens (29) angeordnet ist. Der Kammerboden (29) ist als Teil eines Kammersockels (30) ausgebildet. Zur Erleichterung einer Justage ist es möglich, den Kammersockel (30) im Bereich der Führungsstangen (23) zu fixieren. Eine andere Variante besteht darin, den Kammersockel (30) direkt am Stationsrahmen (16) zu befestigen. Bei einer derartigen Anordnung ist es beispielsweise auch möglich, die Führungsstangen (23) in vertikaler Richtung zweiteilig auszuführen.

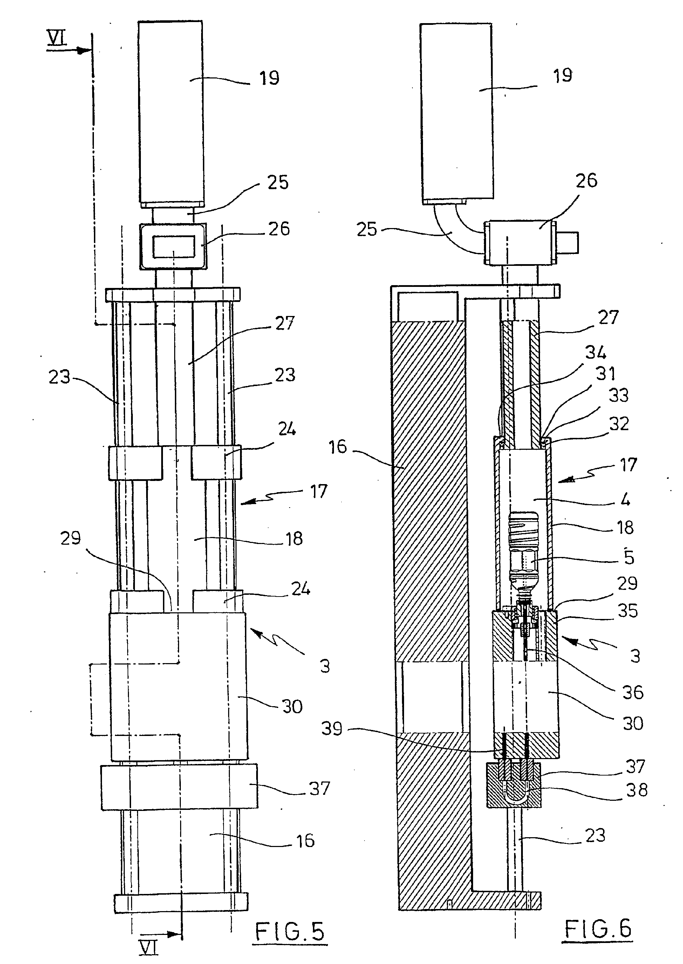

Fig. 5 zeigt eine Vorderansicht der Plasmastation (3) gemäß Fig. 3 in einem geschlossenen Zustand der Plasmakammer (17). Der Schlitten (24) mit der zylinderförmigen Kammerwandung (18) ist hierbei gegenüber der Positionierung in Fig. 4 abgesenkt, so daß die Kammerwandung (18) gegen den Kammerboden (29) gefahren ist. In diesem Positionierzustand kann die Plasmabeschichtung durchgeführt werden.

Fig. 6 zeigt in einer Vertikalschnittdarstellung die Anordnung gemäß Fig. 5. Es ist insbesondere zu erkennen, daß der Kopplungskanal (27) in einen Kammerdeckel (31) einmündet, der einen seitlich überstehenden Flansch (32) aufweist. Im Bereich des Flansches (32) ist eine Dichtung (33) angeordnet, die von einem Innenflansch (34) der Kammerwandung (18) beaufschlagt wird. In einem abgesenkten Zustand der Kammerwandung (18) erfolgt hierdurch eine Abdichtung der Kammerwandung (18) relativ zum Kammerdeckel (31). Eine weitere Dichtung (35) ist in einem unteren Bereich der Kammerwandung (18) angeordnet, um auch hier eine Abdichtung relativ zum Kammerboden (29) zu gewährleisten.

In der in Fig. 6 dargestellten Positionierung umschließt die Kammerwandung (18) die Kavität (4), so daß sowohl ein Innenraum der Kavität (4) als auch ein Innenraum des Werkstückes (5) evakuiert werden können. Zur Unterstützung einer Zuleitung von Prozeßgas ist im Bereich des Kammersokkels (30) eine hohle Lanze (36) angeordnet, die in den Innenraum des Werkstückes (5) hineinverfahrbar ist. Zur Durchführung einer Positionierung der Lanze (36) wird diese von einem Lanzenschlitten (37) gehaltert, der entlang der Führungsstangen (23) positionierbar ist. Innerhalb des Lanzenschlittens (37) verläuft ein Prozeßgaskanal (38), der in der in Fig. 6 dargestellten angehobenen Positionierung mit einem Gasanschluß (39) des Kammersockels (30) gekoppelt ist. Durch diese Anordnung werden schlauchartige Verbindungselemente am Lanzenschlitten (37) vermieden.

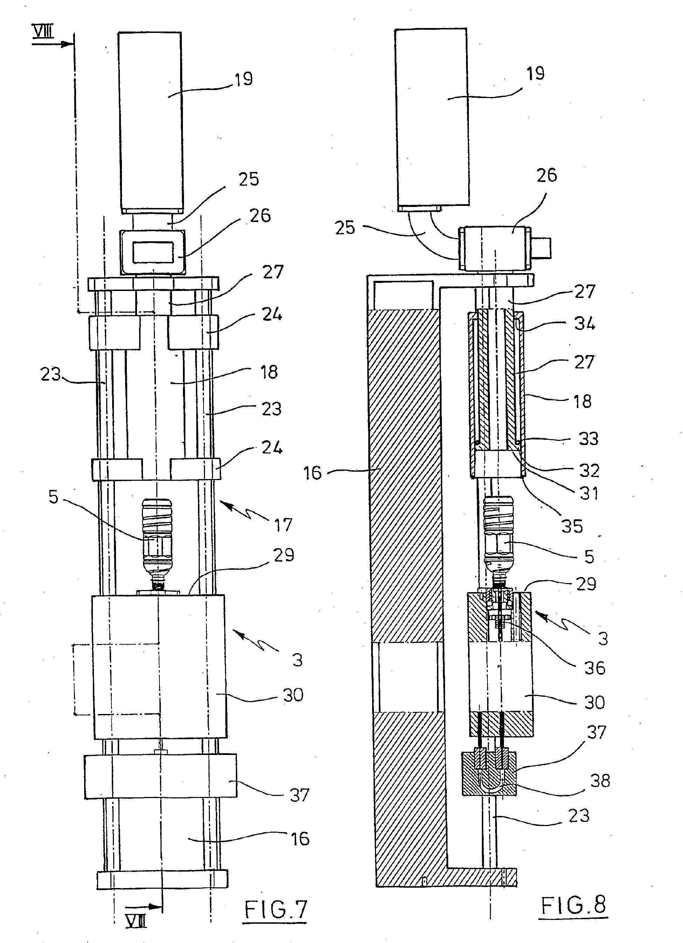

Fig. 7 und Fig. 8 zeigen die Anordnung gemäß Fig. 5 und Fig. 6 in einem angehobenen Zustand der Kammerwandung (18). In diesem Positionierungszustand der Kammerwandung (18) ist es problemlos möglich, das behandelte Werkstück (5) aus dem Bereich der Plasmastation (3) zu entfernen und ein neues zu behandelndes Werkstück (5) einzusetzen. Alternativ zu der in den Zeichnungen dargestellten Positionierung der Kammerwandung (18) in einem durch Verschiebung nach oben erreichten geöffneten Zustand der Plasmakammer (17) ist es auch möglich, den Öffnungsvorgang durch eine Verschiebung einer konstruktiv modifizierten hülsenförmigen Kammerwandung in vertikaler Richtung nach unten durchzuführen.

Im dargestellten Ausführungsbeispiel besitzt der Kopplungskanal (27) eine zylinderförmige Gestaltung und ist im wesentlichen koaxial zur Kammerwandung (18) angeordnet.

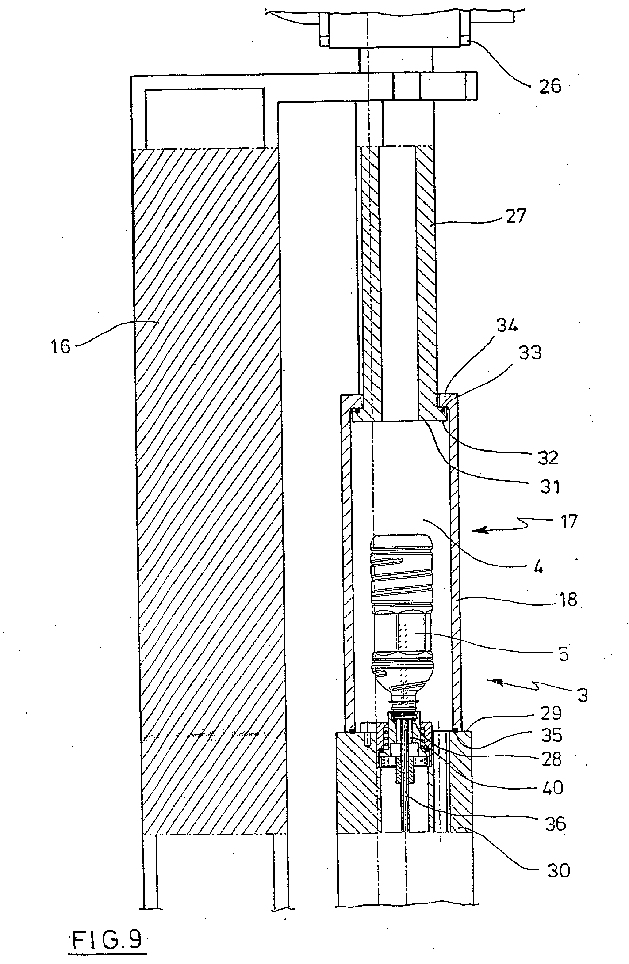

Fig. 9 zeigt den Vertikalschnitt gemäß Fig. 6 in einer vergrößerten teilweisen Darstellung in einer Umgebung der Kammerwandung (18). Zu erkennen ist insbesondere das Übergreifen des Innenflansches (34) der Kammerwandung (18) über den Flansch (32) des Kammerdeckels (31) und die Halterung des Werkstückes (5) durch das Halteelement (28). Darüber hinaus ist zu erkennen, daß die Lanze (36) durch eine Ausnehmung (40) des Halteelementes (28) hindurchgeführt ist.

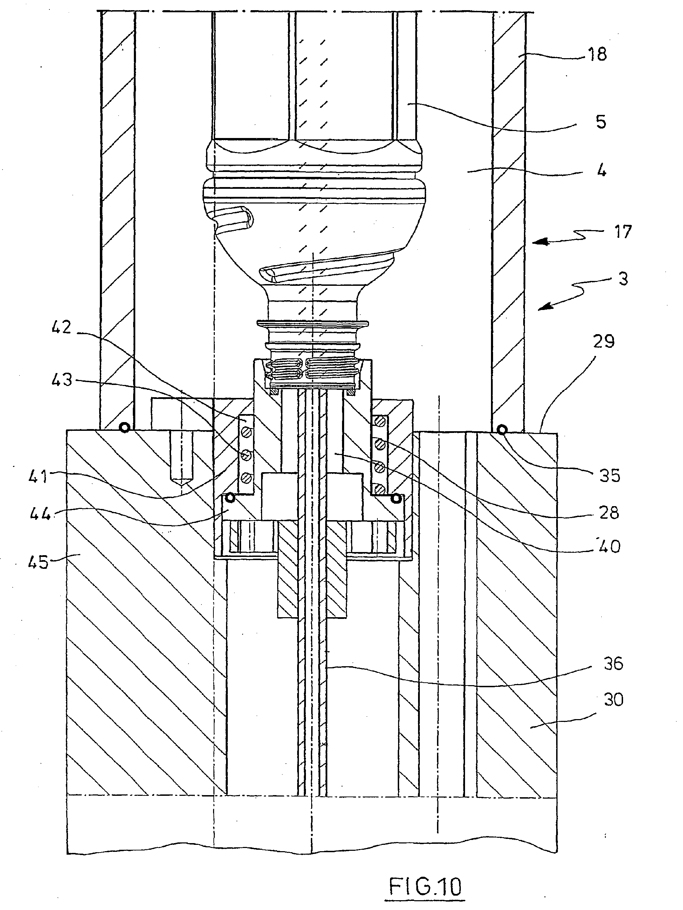

Die Positionierung des Werkstückes (5) im Bereich des Dichtelementes (28) ist in der nochmals vergrößerten Darstellung in Fig. 10 zu erkennen. Das Dichtelement (28) ist in eine Führungshülse (41) eingesetzt, die mit einer Federkammer (42) versehen ist. In die Federkammer (42) ist eine Druckfeder (43) eingesetzt, die einen Außenflansch (44) des Dichtelementes (28) relativ zur Führungshülse (41) verspannt.

In der in Fig. 10 dargestellten Positionierung ist ein an der Lanze (36) montierter Schubteller (45) gegen den Außenflansch (44) geführt und drückt das Dichtelement (28) in seine obere Endpositionierung. In dieser Positionierung ist ein Innenraum des Werkstückes (5) gegenüber dem Innenraum der Kavität (4) isoliert. In einem abgesenkten Zustand der Lanze (36) verschiebt die Druckfeder (43) das Dichtelement (28) relativ zur Führungshülse (41) derart, daß eine Verbindung zwischen dem Innenraum des Werkstückes (5) und dem Innenraum der Kavität (4) geschaffen ist.

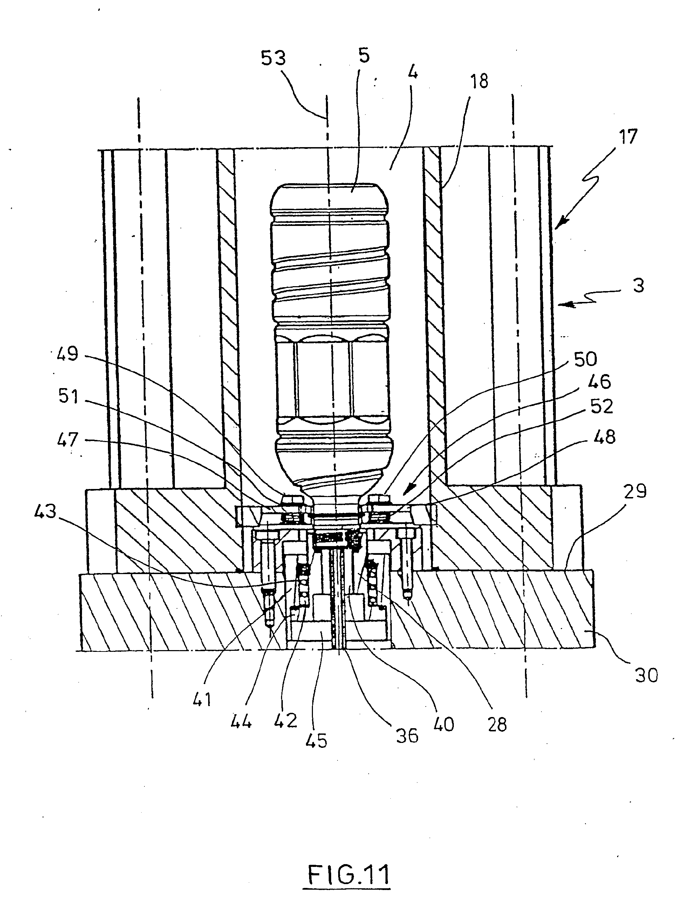

Fig. 11 zeigt die Positionierung des Werkstückes (5) innerhalb der Plasmakammer (17) mit Hilfe eines Halteelementes (46). Das Halteelement (46) ist zangenartig ausgebildet und besitzt zwei verschwenkbar gelagerte Haltearme (47, 48). Die Haltearme (47, 48) sind relativ zu Drehachsen (49, 50) verschwenkbar. Zur Gewährleistung einer automatischen Fixierung des Werkstückes (5) durch das Halteelement (46) werden die Haltearme (47, 48) von Federn (51, 52) in eine jeweilige Haltepositionierung gedrückt.

Das Halteelement (46) ist oberhalb des Kammersockels (30) angeordnet, so daß nach einem Anheben der Kammerwandung (18) eine seitliche Zugänglichkeit des Halteelements (46) gegeben ist. Das Werkstück (5) kann hierdurch von einem Positionierelement an das Halteelement (46) übergeben werden, ohne daß eine Hubbewegung des Werkstückes (5) in Richtung einer Kavitätenlängsachse (53) erfolgen muß.

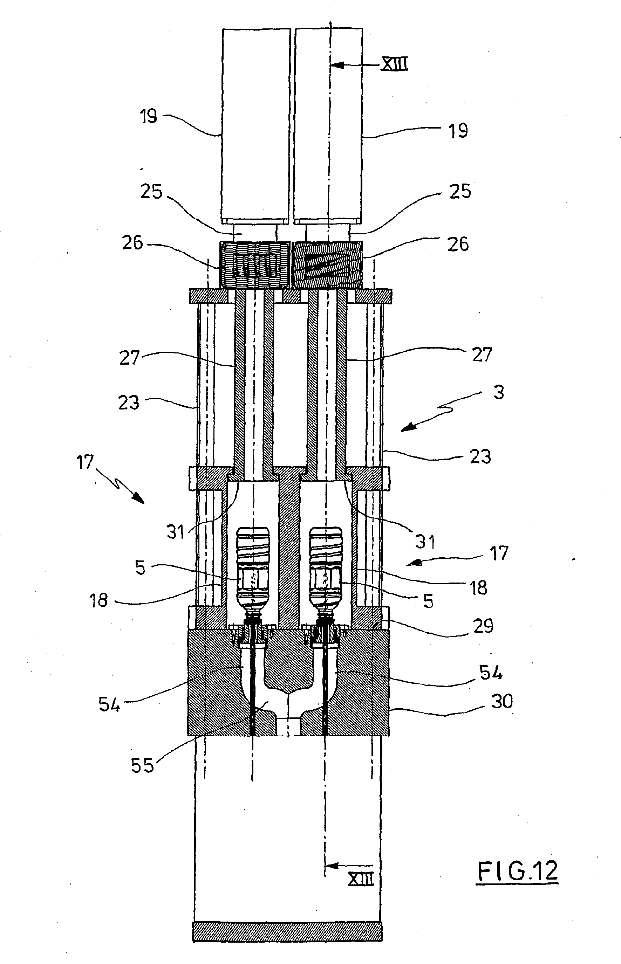

Fig. 12 zeigt eine Plasmastation (3) mit zwei Plasmakammern (17) zur gleichzeitigen Plasmabehandlung von zwei Werkstükken (5). Jede der Plasmakammern (17) ist über einen Kopplungskanal (27) sowie einen Adapter (26) und eine Umlenkung (25) an jeweils einen Mikrowellengenerator (19) angeschlossen. Grundsätzlich ist es ebenfalls denkbar, für zwei oder mehr Plasmakammern (17) einen gemeinsamen Mikrowellengenerator (19) zu verwenden und über eine nicht dargestellte Verzweigung eine Aufteilung der generierten Mikrowellenstrahlung vorzunehmen, um eine gleichmäßige Zündung des Plasmas in jeder der Plasmakammern (17) zu gewährleisten.

In die Plasmakammern (17) münden Kopplungskanäle (54) ein, die jeweils an eine Verzweigung (55) zur Aufteilung einer Menge eines zugeführten Betriebsmittels in zwei Teilmengen angeschlossen sind. Bei einer Verwendung von mehr als zwei Plasmakammern (17) wird die Verzweigung (55) entweder mit einer entsprechenden Anzahl von Ausgängen versehen, oder es werden kaskadiert mehrere Teilverzweigungen hintereinander angeordnet. Die in Fig. 12 dargestellte Anordnung der Verzweigung (55) in unmittelbarer Nähe der Plasmakammer (17) führt zu sehr kurzen Kopplungskanälen (27). Bei einer Zufuhr von Unterdruck hat dies den Vorteil, daß nur ein relativ geringes Volumen der Kopplungskanäle (27) zu evakuieren ist.

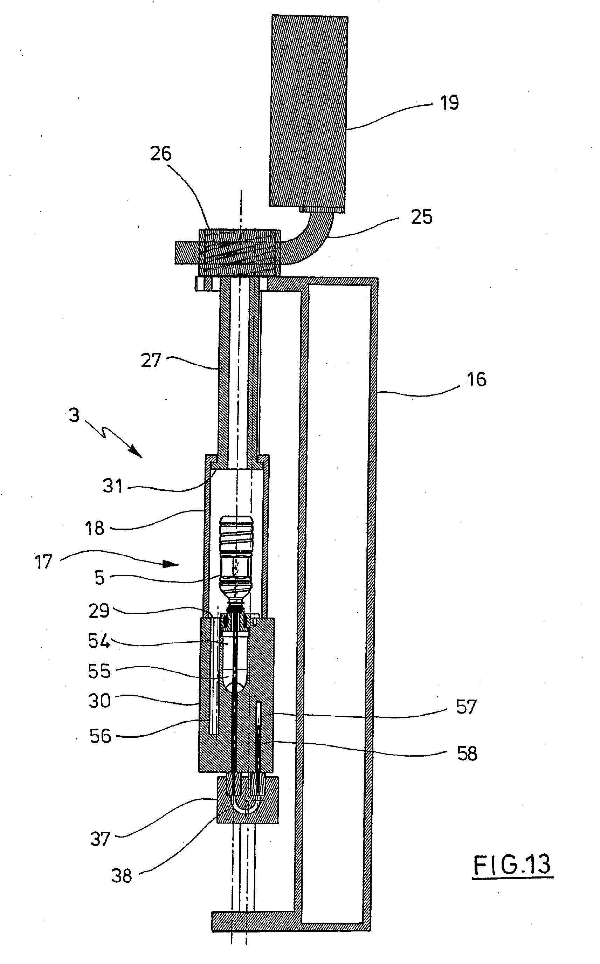

Fig. 13 zeigt einen Vertikalschnitt durch die Anordnung gemäß Fig. 12 bei zusätzlich eingezeichnetem Lanzenschlitten (37). In der dargestellten Positionierung ist die Plasmakammer (17) geschlossen und der Lanzenschlitten (37) gegen den Kammersockel (30) geführt, so daß eine Strömung von Prozeßgas in den Innenraum des Werkstückes (5) hinein gesteuert werden kann.

Im Bereich des Kammersockels (30) sind Kammerkanäle (56) zum Anschluß von Innenräumen der Plasmakammern (17) an die jeweiligen Betriebsmittelzuführungen sowie an den Positionierkanal (57) angeordnet, innerhalb dessen ein Kupplungsrohr (58) längsverschieblich und abgedichtet geführt ist, das eine Verbindung mit dem Plasmagaskanal (38) innerhalb des Lanzenschlittens (37) bereitstellt. Unabhängig von einer jeweiligen Positionierung des Lanzenschlittens (37) zum Kammersockel (30) wird hierdurch die Lanze (36) an eine Prozeßgaszuführung angeschlossen, so daß ein Eindringen von Umgebungsluft in die Prozeßgaszuführung vermieden ist.

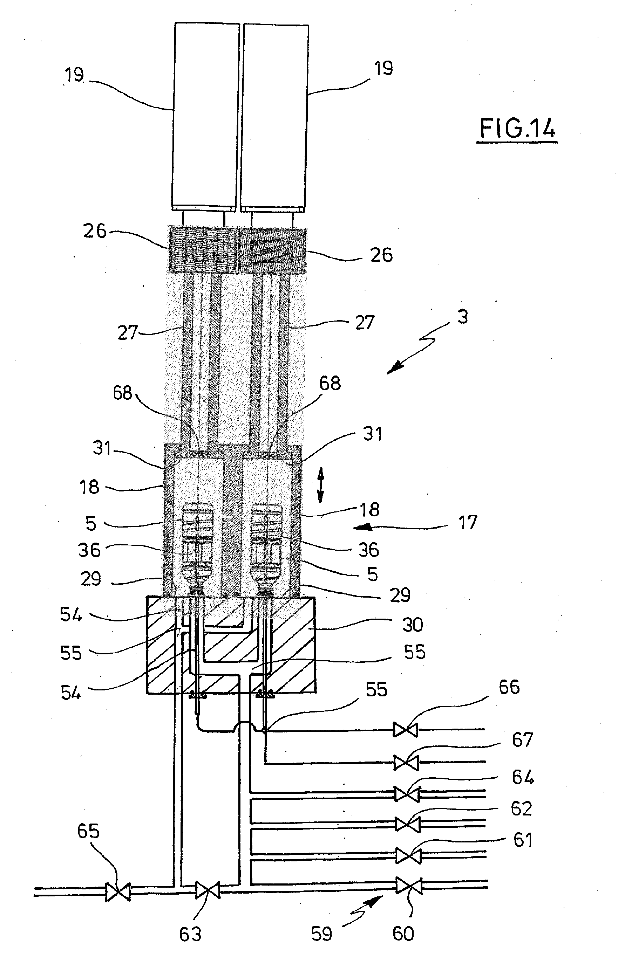

Fig. 14 zeigt die Anordnung gemäß Fig. 12 in einer stark schematisierten Darstellung sowie mit zusätzlicher Darstellung von Ventilen (59) zur Steuerung einer Betriebsmittelzufuhr. Beim dargestellten Ausführungsbeispiel sind aufgrund der schaltungstechnischen Anordnung der Kopplungskanäle (54) drei Verzweigungen (55) verwendet. Zu erkennen sind ebenfalls Quarzglasfenster (68) zur Abdichtung der Innenräume der Plasmakammern (17) relativ zu den Innenräumen der Kopplungskanäle (27) bei gleichzeitiger Durchtrittsmöglichkeit für die Mikrowellenstrahlung.

Gemäß der vorliegenden Ausführungsform werden ein Primärvakuumventil (60) zur Zuführung einer ersten Unterdruckstufe sowie ein Sekundärvakuumventil (61) zur Zuführung eines gegenüber der ersten Unterdruckstufe niedrigeren Unterdruckes verwendet. Zur Aufrechterhaltung des Vakuums synchron zur Zuführung des Prozeßgases ist darüber hinaus ein Prozeßvakuumventil (62) angeordnet. Das Prozeßvakuumventil (62) vermeidet einen Übertritt von abgesaugtem Prozeßgas in die Versorgungskreise für das Primärvakuum und das Sekundärvakuum.

Zur Unterstützung einer wahlweisen oder gemeinsamen Zuführung von Unterdruck zum Innenraum des Werkstückes (5) und / oder in den weiteren Innenraum der Plasmakammer (17) ist ein Kammervakuumventil (63) verwendet, das eine entsprechende Absperrfunktion durchführt. Insbesondere ist daran gedacht, das jeweilige Versorgungsvakuum über die Ventile (60, 61, 62) jeweils unmittelbar dem Innenraum des Werkstückes (5) zuzuführen und über das Kammervakuumventil (63) gesteuert eine bedarfsabhängige Zuschaltung des weiteren Innenraumes der Plasmakammer (17) vorzunehmen.

Zur Unterstützung einer vorgebbaren und voneinander unabhängigen Entlüftung sowohl des Innenraumes des Werkstückes (5) als auch des weiteren Innenraumes der Plasmakammer (17) sind ein Werkstückentlüftungsventil (64) sowie ein Kammerentlüftungsventil (65) verwendet.

Zur Unterstützung einer Zuführung unterschiedlicher Prozeßgaszusammensetzungen sind ein Primärprozeßgasventil (66) sowie ein Sekundärprozeßgasventil (67) verwendet.

Ein typischer Behandlungsvorgang wird im folgenden am Beispiel eines Beschichtungsvorganges erläutert und derart durchgeführt, daß zunächst das Werkstück (5) unter Verwendung des Eingaberades (11) zum Plasmarad (2) transportiert wird und daß in einem hochgeschobenen Zustand der hülsenartigen Kammerwandung (18) das Einsetzen des Werkstückes (5) in die Plasmastation (3) erfolgt. Nach einem Abschluß des Einsetzvorganges wird die Kammerwandung (18) in ihre abgedichtete Positionierung abgesenkt und zunächst gleichzeitig eine Evakuierung sowohl der Kavität (4) als auch eines Innenraumes des Werkstückes (5) durchgeführt.

Nach einer ausreichenden Evakuierung des Innenraumes der Kavität (4) wird die Lanze (36) in den Innenraum des Werkstückes (5) eingefahren und durch eine Verschiebung des Dichtelementes (28) eine Abschottung des Innenraumes des Werkstückes (5) gegenüber dem Innenraum der Kavität (4) durchgeführt. Ebenfalls ist es möglich, die Lanze (36) bereits synchron zur beginnenden Evakuierung des Innenraumes der Kavität in das Werkstück (5) hinein zu verfahren. Der Druck im Innenraum des Werkstückes (5) wird anschließend noch weiter abgesenkt. Darüber hinaus ist auch daran gedacht, die Positionierbewegung der Lanze (36) wenigstens teilweise bereits parallel zur Positionierung der Kammerwandung (18) durchzuführen. Nach Erreichen eines ausreichend tiefen Unterdruckes wird Prozeßgas in den Innenraum des Werkstückes (5) eingeleitet und mit Hilfe des Mikrowellengenerators (19) das Plasma gezündet. Insbesondere ist daran gedacht, mit Hilfe des Plasmas sowohl einen Haftvermittler auf eine innere Oberfläche des Werkstückes (5) als auch die eigentliche Barriereschicht aus Siliziumoxiden abzuscheiden.

Nach einem Abschluß des Beschichtungsvorganges wird die Lanze (36) wieder aus dem Innenraum des Werkstückes (5) entfernt und die Plasmakammer (17) sowie der Innenraum des Werkstückes (5) werden belüftet. Nach Erreichen des Umgebungsdruckes innerhalb der Kavität (4) wird die Kammerwandung (18) wieder angehoben, um eine Entnahme des beschichteten Werkstückes (5) sowie eine Eingabe eines neuen zu beschichtenden Werkstückes (5) durchzuführen. Zur Ermöglichung einer seitlichen Positionierung des Werkstückes (5) wird das Dichtelement (28) mindestens bereichsweise wieder in den Kammersockel (3) hinein verfahren.

Alternativ zur erläuterten Innenbeschichtung von Werkstükken (5) können auch Außenbeschichtungen, Sterilisationen oder Oberflächenaktivierungen durchgeführt werden.

Eine Positionierung der Kammerwandung (18), des Dichtelementes (28) und / oder der Lanze (36) kann unter Verwendung unterschiedlicher Antriebsaggregate erfolgen. Grundsätzlich ist die Verwendung pneumatischer Antriebe und / oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades (2) eine Kurvensteuerung zu realisieren. Die Kurvensteuerung kann beispielsweise derart ausgeführt sein, daß entlang eines Umfanges des Plasmarades (2) Steuerkurven angeordnet sind, entlang derer Kurvenrollen geführt werden. Die Kurvenrollen sind mit den jeweils zu positionierenden Bauelementen gekoppelt.

Über die Verzweigungen (55) ist es grundsätzlich möglich, mehrere Plasmakammern (17) an gemeinsame Ventile (59) anzuschließen. Alternativ oder zusätzlich ist es möglich, über die Verzweigungen mehrere Kavitäten innerhalb einer Plasmakammer mit gemeinsamen Ventilen (59) zu verbinden. Schließlich ist auch daran gedacht, alternativ oder ergänzend zu den obigen Varianten mehrere Innenräume von Werkstücken (5) innerhalb einer gemeinsamen Plasmakammer (17) oder innerhalb einer gemeinsamen Kavität mit gemeinsamen Ventilen (59) zu verbinden.

Die Betätigung der Ventile (59) erfolgt vorzugsweise über eine programmierbare elektronische Steuerung. Zunächst wird nach einem Schließen der Plasmakammer (17) das Primärvakuumventil (60) geöffnet und der Innenraum des Werkstückes (5) und der Innenraum der Plasmakammer (17) gleichzeitig evakuiert. Hierbei wird ein Druckniveau im Bereich von 20 mbar bis 50 mbar erreicht. Nach einem Schließen des Primärvakuumventils (60) erfolgt ein Öffnen des Sekundärvakuumventils (61) und der Innenraum des Werkstückes (5) und der Innenraum der Plasmakammer (17) werden zunächst gleichzeitig an eine Unterdruckquelle mit einem niedrigeren Druckniveau angeschlossen. Nach einer ausreichenden Evakuierung des das Werkstück (5) umgebenden Innenraumes der Plasmakammer (17) schließt das Kammervakuumventil (63) und lediglich der Innenraum des Werkstückes (5) wird weiter evakuiert. Hierbei wird ein Druckniveau von etwa 0,1 mbar erreicht.

Nach einem Schließen des Kammervakuumventils (63) und einer in der Regel bereits zuvor erfolgten Positionierung der Lanze (36) innerhalb des Innenraumes des Werkstückes (5) öffnet das Primärprozeßgasventil (66) und ein Prozeßgas einer ersten Zusammensetzung wird zugeführt. Zur Prozeßgasversorgung der Lanze (36) ist insbesondere daran gedacht, die beispielsweise in Fig. 6 dargestellten Gasanschlüsse (39) im Bereich des Kammersockels (30) derart auszuführen, daß innerhalb einer bohrungsartigen Ausnehmung ein rohrartiges Kupplungselement in einer Längsrichtung verschieblich geführt ist. Eine Abdichtung kann über eine dynamische Ringdichtung erfolgen. Das rohrartige Verbindungselement ist vom Lanzenschlitten (37) getragen und stellt eine Verbindung zum Plasmagaskanal (38) innerhalb des Lanzenschlittens (37) her. Durch eine entsprechende Verschiebung des rohrartigen Verbindungselementes innerhalb der bohrungsartigen Ausnehmung ist für jede Positionierung des Lanzenschlittens (37) eine Verbindung mit der Prozeßgasverteilung gewährleistet.

Nach einer ausreichenden Prozeßgaszuführung zündet der Mikrowellengenerator (19) das Plasma im Innenraum des Werkstückes (5). Zu einem vorgebbaren Zeitpunkt schließt das Primärprozeßgasventil (66) und das Sekundärprozeßgasventil (67) öffnet zur Zuführung eines Prozeßgases einer zweiten Zusammensetzung. Zumindest zeitweise parallel zum Öffnen der Prozeßgasventile (66, 67) öffnet auch das Prozeßvakuumventil (62), um einen ausreichend niedrigen Unterdruck im Innenraum des Werkstückes (5) aufrecht zu erhalten. Hierbei erweist sich ein Druckniveau von etwa 0,3 mbar als zweckmäßig

Nach einem Abschluß der Plasmabeschichtung öffnet zunächst das Werkstückentlüftungsventil (64) und schließt den Innenraum des Werkstückes (5) an einen Umgebungsdruck an. Mit einer vorgebbaren zeitlichen Verzögerung nach einem Öffnen des Werkstückentlüftungsventils (64) öffnet auch das Kammerentlüftungsventil (65), um den Innenraum der Plasmakammer (17) wieder vollständig auf den Umgebungsdruck anzuheben. Nach einem zumindest annäherungsweise Erreichen des Umgebungsdruckes innerhalb der Plasmakammer (17) kann die Plasmakammer (17) öffnen und das beschichtete Werkstück (5) wird entnommen und durch ein neues zu beschichtendes Werkstück (5) ersetzt.

Zur Entfernung eventueller Rückstände des Plasmabehandlungsverfahrens innerhalb des Werkstückes (5) ist es möglich, vor einer Entnahme des Werkstückes (5) aus der Plasmakammer (17) Druckluft in das Werkstück (5) einzubringen und hierdurch die eventuellen Verunreinigungen zu entfernen. Die Ableitung der Druckluft kann entweder in eine Umgebung der Plasmastation (3) erfolgen, insbesondere ist aber auch daran gedacht, gleichzeitig zur Druckbeaufschlagung auch einen der Unterdruckanschlüsse zu aktivieren und hierdurch ein definiertes Absaugen der Verunreinigungen durchzuführen. Alternativ ist ebenfalls daran gedacht, den Reinigungsvorgang ausschließlich durch eine zusätzliche Unterdruckbeaufschlagung durchzuführen und den Reinigungsvorgang durch nachströmende Umgebungsluft durchzuführen.

Bei einer Druckluftzuführung ist insbesondere an eine Zuführung durch die Lanze (36) hindurch gedacht, da hierdurch die Spülluft in einen Bereich des Innenraumes des Werkstükkes (5) eingebracht werden kann, der einer Öffnung des Werkstückes (5) abgewandt angeordnet ist. Hierdurch wird eine Spülluftströmung in Richtung auf die Öffnung des Werkstückes (5) unterstützt und ein wirksamer Reinigungsvorgang durchgeführt.

## Patentansprüche

1. Verfahren zur Plasmabehandlung von Werkstücken (5), bei dem das Werkstück (5) in eine zumindest teilweise evakuierbare Kammer (17) einer Behandlungsstation eingesetzt wird und bei dem das Werkstück (5) innerhalb der Behandlungsstation von einem Halteelement (46) positioniert wird, und bei dem zur gleichzeitigen Versorgung von mindestens zwei Kammern mit mindestens einem Betriebsmittel eine Strömung des Betriebsmittels mindestens einmal von einer Verzweigung (55) in mindestens zwei Teilströme verzweigt wird, sowie bei dem ein Innenraum eines hohlkörperartigen Werkstückes (5) behandelt wird, wobei die mindestens eine Plasmastation (3) von einem rotierenden Plasmarad (2) von einer Eingabepositionierung in eine Ausgabepositionierung überführt wird, und wobei von einem Primärvakuumventil (60) ein erster Unterdruck und von einem Sekundärvakuumventil (61) ein relativ zum ersten Unterdruck niedrigerer zweiter Unterdruck zugeschaltet wird, wobei die Verzweigung (55) im Bereich eines Kammersockels (30) angeordnet wird, **dadurch gekennzeichnet, daß** zum Einsetzen und Entnehmen des Werkstückes (5) einen hülsenförmige Kammerwandung (18) der Kammern hochgeschoben und anschließend abgesenkt wird.

2. Verfahren nach Anspruch 1, **dadurch gekennzeichnet, daß** die Verzweigung (55) in einer vertikalen Richtung durchgeführt wird.

3. Verfahren nach Anspruch 1, **dadurch gekennzeichnet, daß** die Verzweigung (55) in einer horizontalen Richtung durchgeführt wird.

4. Verfahren nach einem der Ansprüche 1 bis 3, **dadurch gekennzeichnet, daß** eine Evakuierung einer Kavität (4) der Plasmastation (3) durch den Kammerboden (29) hindurch erfolgt.

5. Verfahren nach einem der Ansprüche 1 bis 4, **dadurch gekennzeichnet, daß** durch den Kammerboden (29) hindurch Prozeßgas zugeführt wird.

6. Verfahren nach einem der Ansprüche 1 bis 5, **dadurch gekennzeichnet, daß** das Prozeßgas durch eine Lanze (36) hindurch in einen Innenraum des Werkstückes (5) zugeführt wird.

7. Verfahren nach einem der Ansprüche 1 bis 6, **dadurch gekennzeichnet, daß** mindestens ein Betriebsmittel von mindestens einer Verzweigung (55) direkt in mindestens zwei Kammern eingeleitet wird.

8. Verfahren nach einem der Ansprüche 1 bis 6, **dadurch gekennzeichnet, daß** mindestens ein Betriebsmittel von mindestens einer Verzweigung (55) in Innenräume von mindestens zwei Werkstücken (5) eingeleitet wird.

9. Verfahren nach einem der Ansprüche 1 bis 6, **dadurch gekennzeichnet, daß** mindestens ein Betriebsmittel von mindestens einer Verzweigung (55) in mindestens zwei Lanzen (36) eingeleitet wird.

10. Verfahren nach einem der Ansprüche 1 bis 9, **dadurch gekennzeichnet, daß** von der Verzweigung (55) eine Unterdruckzuführung verteilt wird.

11. Verfahren nach einem der Ansprüche 1 bis 9, **dadurch gekennzeichnet, daß** von der Verzweigung (55) eine Prozeßgaszuführung verteilt wird

12. Verfahren nach einem der Ansprüche 1 bis 9, **dadurch gekennzeichnet, daß** von der Verzweigung (55) eine Belüftungszuführung verteilt wird.

13. Verfahren nach einem der Ansprüche 1 bis 12, **dadurch gekennzeichnet, daß** im Bereich des Kammerdeckels (31) von einem Mikrowellengenerator (19) erzeugte Mikrowellen in die Kavität (4) eingeleitet werden.

14. Verfahren nach einem der Ansprüche 1 bis 13, **dadurch gekennzeichnet, daß** ein Werkstück (5) aus einem thermoplastischen Kunststoff behandelt wird.

15. Verfahren nach einem der Ansprüche 1 bis 14, **dadurch gekennzeichnet, daß** als Werkstück (5) ein Behälter behandelt wird.

16. Verfahren nach einem der Ansprüche 1 bis 15, **dadurch gekennzeichnet, daß** als Werkstück (5) eine Getränkeflasche behandelt wird.

17. Verfahren nach einem der Ansprüche 1 bis 16, **dadurch gekennzeichnet, daß** von einer Plasmastation (3) mehrere Kavitäten (4) bereitgestellt werden.

18. Verfahren nach einem der Ansprüche 1 bis 17, **dadurch gekennzeichnet, daß** von einer Verzweigung eine Mikrowellenzuführung verteilt wird

19. Verfahren nach einem der Ansprüche 1 bis 18, **dadurch gekennzeichnet, daß** als Plasmabehandlung eine Plasmabeschichtung durchgeführt wird.

20. Verfahren nach einem der Ansprüche 1 bis 19, **dadurch gekennzeichnet, daß** die Plasmabehandlung unter Verwendung eines Niederdruckplasmas durchgeführt wird.

21. Verfahren nach einem der Ansprüche 1 bis 20, **dadurch gekennzeichnet, daß** eine Plasmapolymerisation durchgeführt wird.

22. Verfahren nach einem der Ansprüche 1 bis 21, **dadurch gekennzeichnet, daß** durch das Plasma mindestens zum Teil organische Substanzen abgeschieden werden.

23. Verfahren nach einem der Ansprüche 1 bis 21, **dadurch gekennzeichnet, daß** durch das Plasma mindestens zum Teil anorganische Substanzen abgeschieden werden.

24. Verfahren nach einem der Ansprüche 1 bis 23, **dadurch gekennzeichnet, daß** durch das Plasma eine Substanz zur Verbesserung von Barriereeigenschaften des Werkstückes (5) abgeschieden wird.

25. Verfahren nach Anspruch 24, **dadurch gekennzeichnet, daß** zusätzlich ein Haftvermittler zur Verbesserung eines Anhaftens der Substanz auf einer Oberfläche des Werkstückes (5) abgeschieden wird.

26. Verfahren nach einem der Ansprüche 1 bis 25, **dadurch gekennzeichnet, daß** in einer gemeinsamen Kavität mindestens zwei Werkstücke (5) gleichzeitig behandelt werden.

27. Verfahren nach einem der Ansprüche 1 bis 18, **dadurch gekennzeichnet, daß** als Plasmabehandlung eine Plasmasterilisation durchgeführt wird.

28. Verfahren nach einem der Ansprüche 1 bis 18, **dadurch gekennzeichnet, daß** als Plasmabehandlung eine Oberflächenaktivierung des Werkstückes (5) durchgeführt wird.

29. Vorrichtung zur Plasmabehandlung von Werkstücken (5), die mindestens eine evakuierbare Plasmakammer (17) zur Aufnahme der Werkstücke (5) aufweist und bei der die Plasmakammer (17) im Bereich einer Behandlungsstation angeordnet ist, sowie bei der die Plasmakammer (17) von einem Kammerboden (29), einem Kammerdeckel (31) sowie einer seitlichen Kammerwandung (18) begrenzt ist und mindestens ein Halteelement (46) zur Positionierung des Werkstückes (5) aufweist, und bei der mindestens zwei Plasmakammern (17) an mindestens eine Verzweigung (55) zur Aufteilung einer Strömung eines Betriebsmittels in mindestens zwei Teilströmungen angeschlossen sind, sowie bei der die Plasmastation (3) zur Beschichtung eines Innenraumes eines hohlkörperartigen werkstückes (5) ausgebildet und die mindestens eine Plasmastation (3) von einem rotierenden Plasmarad (2) getragen ist, wobei mindestens eine Verzweigung (55) an ein Primärvakuumventil (60) zur Zuschaltung eines ersten Unterdruckes angeschlossen ist und wobei mindestens eine Verzweigung (55) an ein Sekundärvakuumventil (61) zur Zuschaltung eines relativ zum ersten Unterdruck niedrigeren Unterdruckes angeschlossen ist und mindestens eine Verzweigung (55) im Bereich eines Kammersockels (30) der Plasmastation (3) angeordnet ist, **dadurch gekennzeichnet, daß** die Kammerwandung (18) hülsenförmig ausgebildet sowie hochschiebbar und absenkbar angeordnet ist.

30. Vorrichtung nach Anspruch 29, **dadurch gekennzeichnet, daß** die Verzweigung (55) in einer vertikalen Richtung verläuft.

31. Vorrichtung nach Anspruch 29, **dadurch gekennzeichnet, daß** die Verzweigung (55) in einer horizontalen Richtung verläuft.

32. Vorrichtung nach einem der Ansprüche 29 bis 31, **dadurch gekennzeichnet, daß** für eine Evakuierung einer Kavität (4) der Plasmastation (3) im Kammerboden (29) mindestens ein Vakuumkanal angeordnet ist.

33. Vorrichtung nach einem der Ansprüche 29 bis 32, **dadurch gekennzeichnet, daß** im Kammerboden (29) mindestens ein Kanal zur Zuführung von Prozeßgas angeordnet ist.

34. Vorrichtung nach einem der Ansprüche 29 bis 33, **dadurch gekennzeichnet, daß** zur Zuführung von Prozeßgas in einen Innenraum des Werkstückes (5) hinein eine Lanze (36) relativ zum Kammerboden (29) positionierbar angeordnet ist.

35. Vorrichtung nach einem der Ansprüche 29 bis 34, **dadurch gekennzeichnet, daß** mindestens eine Verzweigung (55) direkt an Innenräume von mindestens zwei Plasmakammern (17) angeschlossen ist.

36. Vorrichtung nach einem der Ansprüche 29 bis 35, **dadurch gekennzeichnet, daß** mindestens eine Verzweigung (55) an einen Kopplungskanal (54) zur Verbindung von Innenräumen von mindestens zwei Werkstücken (5) angeschlossen ist.

37. Vorrichtung nach einem der Ansprüche 29 bis 36, **dadurch gekennzeichnet, daß** mindestens eine Verzweigung (55) an mindestens zwei Lanzen (36) angeschlossen ist.

38. Vorrichtung nach einem der Ansprüche 29 bis 37, **dadurch gekennzeichnet, daß** mindestens eine Verzweigung (55) an mindestens eine Unterdruckversorgung angeschlossen ist.

39. Vorrichtung nach einem der Ansprüche 29 bis 37, **dadurch gekennzeichnet, daß** mindestens eine Verzweigung (55) an mindestens eine Prozeßgasversorgung angeschlossen ist.

40. Vorrichtung nach einem der Ansprüche 29 bis 37, **dadurch gekennzeichnet, daß** mindestens eine Verzweigung (55) an mindestens eine Belüftungszuführung angeschlossen ist.

41. Vorrichtung nach einem der Ansprüche 29 bis 40, **dadurch gekennzeichnet, daß** im Bereich des Kammerdeckels (31) ein Mikrowellengenerator (19) angeordnet ist.

42. Vorrichtung nach einem der Ansprüche 29 bis 41, **dadurch gekennzeichnet, daß** die Plasmastation (3) zur Beschichtung eines Werkstückes (5) aus einem thermoplastischen Kunststoff ausgebildet ist.

43. Vorrichtung nach einem der Ansprüche 29 bis 42, **dadurch gekennzeichnet, daß** die Plasmastation (3) zur Beschichtung eines behälterartigen Werkstückes (5) ausgebildet ist.

44. Vorrichtung nach einem der Ansprüche 29 bis 43, **dadurch gekennzeichnet, daß** die Plasmastation (3) zur Beschichtung eines Werkstückes (5) in Form einer Getränkeflasche ausgebildet ist.

45. Vorrichtung nach einem der Ansprüche 29 bis 44, **dadurch gekennzeichnet, daß** im Bereich der Plasmastation (3) mehrere Kavitäten (4) angeordnet sind.

46. Vorrichtung nach einem der Ansprüche 29 bis 45, **dadurch gekennzeichnet, daß** eine zur Bereitstellung von mindestens zwei Kavitäten (4) vorgesehene Kammerwandung (18) positionierbar angeordnet ist.

47. Vorrichtung nach einem der Ansprüche 29 bis 46, **dadurch gekennzeichnet, daß** mindestens eine Verzweigung (55) an mindestens einen Mikrowellengenerator (19) angeschlossen ist.

48. Vorrichtung nach Anspruch 29, **dadurch gekennzeichnet, daß** das Primärvakuumventil (60) mindestens zeitweilig sowohl einen Innenraum des Werkstückes (5) als auch einen weiteren Innenraum der Plasmakammer (17) an eine gemeinsame Unterdruckversorgung anschließt.

49. Vorrichtung nach einem der Ansprüche 29 bis 48, **dadurch gekennzeichnet, daß** das Sekundärvakuumventil (61) mindestens zeitweilig ausschließlich einen Innenraum des Werkstückes (5) mit der Unterdruckquelle verbindet.

50. Vorrichtung nach einem der Ansprüche 29 bis 49, **dadurch gekennzeichnet, daß** mindestens eine Verzweigung (55) an ein Werkstückentlüftungsventil (64) zur Verbindung eines Innenraumes des Werkstückes (5) mit einem Umgebungsdruck angeschlossen ist.

51. Vorrichtung nach einem der Ansprüche 29 bis 50, **dadurch gekennzeichnet, daß** mindestens eine Verzweigung (55) an ein Kammerentlüftungsventil (61) zur Verbindung eines Innenraumes der Plasmakammer (17) mit einem Umgebungsdruck angeschlossen ist.

52. Vorrichtung nach einem der Ansprüche 29 bis 51, **dadurch gekennzeichnet, daß** mindestens eine Verzweigung (55) an ein Primärprozeßgasventil (66) angeschlossen ist.

53. Vorrichtung nach einem der Ansprüche 29 bis 52, **dadurch gekennzeichnet, daß** mindestens eine Verzweigung (55) an ein Sekundärprozeßgasventil (67) angeschlossen ist.

54. Vorrichtung nach einem der Ansprüche 29 bis 53, **dadurch gekennzeichnet, daß** mindestens eine Verzweigung (55) an ein Prozeßvakuumventil (62) angeschlossen ist.

55. Vorrichtung nach einem der Ansprüche 29 bis 54, **dadurch gekennzeichnet, daß** mindestens eine Verzweigung (55) an ein Kammervakuumventil (63) angeschlossen ist.

56. Vorrichtung nach einem der Ansprüche 29 bis 55, **dadurch gekennzeichnet, daß** mindestens eine Verzweigung (55) in lotrechter Richtung unterhalb des Kammerbodens (29) angeordnet ist.

57. Vorrichtung nach einem der Ansprüche 29 bis 56, **dadurch gekennzeichnet, daß** mindestens eine Verzweigung (55) mit dem Kammersockel (30) ein gemeinsames Bauteil ausbildet.

58. Vorrichtung nach einem der Ansprüche 29 bis 57, **dadurch gekennzeichnet, daß** mindestens zwei der Ventile (59) im Bereich eines gemeinsamen Ventilblockes angeordnet sind.

59. Vorrichtung nach einem der Ansprüche 29 bis 58, **dadurch gekennzeichnet, daß** mindestens eine der Verzweigungen (55) im Bereich des Ventilblockes angeordnet ist.

60. Vorrichtung nach Anspruch 58 oder 59, **dadurch gekennzeichnet, daß** der Ventilblock mit den mindestens zwei Ventilen (59) und der mindestens einen Verzweigung (55) in lotrechter Richtung unterhalb des Kammersockels (30) angeordnet ist.

61. Vorrichtung nach einem der Ansprüche 29 bis 60, **dadurch gekennzeichnet, daß** der Ventilblock mit mindestens einer Verzweigung (55) ein gemeinsames Bauteil ausbildet.

62. Vorrichtung nach einem der Ansprüche 29 bis 61, **dadurch gekennzeichnet, daß** mindestens eines der Ventile (59) als ein elektromagnetisch gesteuertes Ventil ausgebildet ist.

## Claims

1. A method for the plasma treatment of workpieces (5) in which the workpiece (5) is inserted into a chamber (17) of a treatment station, wherein said chamber (17) can be evacuated at least in part, and in which the workpiece (5) is positioned within the treatment station by a retaining element (46) and in which, to simultaneously supply at least two chambers with at least one operating medium, a flow of the operating medium is branched into two partial flows by a furcation (55) at least once, as well as in which an interior region of a hollow-type workpiece (5) is treated, wherein a rotating plasma wheel (2) puts the at least one plasma station (3) from an input position into an output position and wherein a primary vacuum valve (60) activates a first vacuum pressure and a secondary vacuum valve (61) activates a second vacuum pressure that is lower than the first vacuum pressure, wherein the furcation (55) is arranged in the region of a chamber base (30),
**characterised in that**
- a sleeve-type chamber wall (18) of the chamber is moved up and subsequently moved down to insert and remove the workpiece (5).

2. The method according to Claim 1, **characterised in that** the furcation (55) is achieved in a vertical direction.

3. The method according to Claim 1, **characterised in that** the furcation (55) is achieved in a horizontal direction.

4. The method according to any one of Claims 1 to 3, **characterised in that** an evacuation of a cavity (4) of the plasma station (3) is achieved through the chamber bottom (29).

5. The method according to any one of Claims 1 to 4, **characterised in that** process gas is supplied through the chamber bottom (29).

6. The method according to any one of Claims 1 to 5, **characterised in that** the process gas is supplied through a lance (36) and into an interior region of the workpiece (5).

7. The method according to any one of Claims 1 to 6, **characterised in that** at least one operating medium is directly introduced into at least two chambers by at least one furcation (55).

8. The method according to any one of Claims 1 to 6, **characterised in that** at least one operating medium is introduced into interior regions of at least two workpieces (5) by at least one furcation (55).

9. The method according to any one of Claims 1 to 6 **characterised in that** at least one operating medium is introduced into at least two lances (36) by at least one furcation (55).

10. The method according to any one of Claims 1 to 9, **characterised in that** a vacuum pressure supply is distributed by the furcation (55).

11. The method according to any one of Claims 1 to 9, **characterised in that** a process gas supply is distributed by the furcation (55).

12. The method according to any one of Claims 1 to 9, **characterised in that** a ventilation supply is distributed by the furcation (55).

13. The method according to any one of Claims 1 to 12, **characterised in that**, in the vicinity of the chamber lid (31), microwaves generated by a microwave generator (19) are introduced into the cavity (4).

14. The method according to any one of Claims 1 to 13, **characterised in that** a workpiece (5) that is made of a thermoplastic resin is treated.

15. The method according to any one of Claims 1 to 14, **characterised in that** a container is treated as workpiece (5).

16. The method according to any one of Claims 1 to 15, **characterised in that** a beverage bottle is treated as workpiece (5).

17. The method according to any one of Claims 1 to 16, **characterised in that** a plurality of cavities (4) is made available by a plasma station (3).

18. The method according to any one of Claims 1 to 17, **characterised in that** a microwave supply is distributed by a furcation.

19. The method according to any one of Claims 1 to 18, **characterised in that** a plasma coating is carried out as plasma treatment.

20. The method according to any of Claims 1 to 19, **characterised in that** the plasma treatment is carried out using a low pressure plasma.

21. The method according to any of Claims 1 to 20, **characterised in that** a plasma polymerisation is carried out.

22. The method according to any of Claims 1 to 21, **characterised in that** organic substances are separated by the plasma at least in part.

23. The method according to any of Claims 1 to 21, **characterised in that** inorganic substances are separated by the plasma at least in part.

24. The method according to any of Claims 1 to 23, **characterised in that** a substance for improving barrier properties of a workpiece (5) is separated by the plasma.

25. The method according to Claim 24, **characterised in that**, in addition, an adhesion promoter is separated to improve the adhesion of the substance to a surface of the workpiece (5).

26. The method according to any one of Claims 1 to 25, **characterised in that** at least two workpieces (5) are treated at the same time in one common cavity.

27. The method according to any of Claims 1 to 18, **characterised in that** a plasma sterilisation is carried out as plasma treatment.

28. The method according to any of Claims 1 to 18, **characterised in that** a surface activation of the workpiece (5) is carried out as plasma treatment.

29. An apparatus for the plasma treatment of workpieces (5), which comprises at least one plasma chamber (17) that can be evacuated and is provided to receive the workpieces (5) and in which the plasma chamber (17) is arranged in the vicinity of a treatment station as well as in which the plasma chamber (17) is delimited by a chamber bottom (29), a chamber lid (31) as well as a lateral chamber wall (18) and comprises at least one retaining element (46) for positioning the workpiece (5), and in which at least two plasma chambers (17) are connected to at least one furcation (55) to separate a flow of an operating medium into at least two partial flows, as well as in which the plasma station (3) is formed to coat an interior region of a hollow-type workpiece (5) and the at least one plasma station (3) is supported by a rotating plasma wheel (2), wherein
at least one furcation (55) is connected to a primary vacuum valve (60) to activate a first vacuum pressure and wherein at least one furcation (55) is connected to a secondary vacuum valve (61) to activate a vacuum pressure that is lower than the first vacuum pressure and at least one furcation (55) is arranged in the vicinity of a chamber base (30) of the plasma station (3),
**characterised in that**
- the chamber wall (18) is formed like a sleeve and is arranged such that it can be moved up and moved down.

30. The apparatus according to Claim 29, **characterised in that** the furcation (55) extends in a vertical direction.

31. The apparatus according to Claim 29, **characterised in that** the furcation (55) extends in a horizontal direction.

32. The apparatus according to any one of Claims 29 to 31, **characterised in that**, to evacuate a cavity (4) of the plasma station (3), at least one vacuum duct is arranged in the chamber bottom (29).

33. The apparatus according to any one of Claims 29 to 32, **characterised in that** at least one duct for supplying process gas is arranged in the chamber bottom (29).

34. The apparatus according to any one of Claims 29 to 33, **characterised in that**, to supply process gas into an interior region of the workpiece (5), a lance (36) is arranged such that it can be positioned relative to the chamber bottom (29).

35. The apparatus according to any one of Claims 29 to 34, **characterised in that** at least one furcation (55) is directly connected to interior regions of at least two plasma chambers (17).

36. The apparatus according to any one of Claims 29 to 35, **characterised in that** at least one furcation (55) is connected to a coupling duct (54) to connect interior regions of at least two workpieces (5).

37. The apparatus according to any one of Claims 29 to 36, **characterised in that** at least one furcation (55) is connected to at least two lances (36).

38. The apparatus according to any one of Claims 29 to 37, **characterised in that** at least one furcation (55) is connected to at least one vacuum pressure supply.

39. The apparatus according to any one of Claims 29 to 37, **characterised in that** at least one furcation (55) is connected to at least one process gas supply.

40. The apparatus according to any one of Claims 29 to 37, **characterised in that** at least one furcation (55) is connected to at least one ventilation supply.

41. The apparatus according to any one of Claims 29 to 40, **characterised in that** a microwave generator (19) is arranged in the vicinity of the chamber lid (31).

42. The apparatus according to any one of Claims 29 to 41, **characterised in that** the plasma station (3) is formed to coat a workpiece (5) that is made of thermoplastic resin.

43. The apparatus according to any one of Claims 29 to 42, **characterised in that** the plasma station (3) is formed to coat a container-type workpiece (5).

44. The apparatus according to any one of Claims 29 to 43, **characterised in that** the plasma station (3) is formed to coat a workpiece (5) having the form of a beverage bottle.

45. The apparatus according to any one of Claims 29 to 44, **characterised in that** a plurality of cavities (4) is arranged in the vicinity of the plasma station (3).

46. The apparatus according to any one of Claims 29 to 45, **characterised in that** a chamber wall (18) provided for making available at least two cavities (4) is arranged such that it can be positioned.

47. The apparatus according to any one of Claims 29 to 46, **characterised in that** at least one furcation (55) is connected to at least one microwave generator (19).

48. The apparatus according to Claim 29, **characterised in that** the primary vacuum valve (60) connects both an interior region of the workpiece (5) and a further interior region of the plasma chamber (17) to a common vacuum pressure supply at least temporarily.

49. The apparatus according to any one of Claims 29 to 48, **characterised in that** the secondary vacuum valve (61) exclusively connects an interior region of the workpiece (5) to the vacuum pressure source at least temporarily.

50. The apparatus according to any one of Claims 29 to 49, **characterised in that** at least one furcation (55) is connected to a workpiece exhaust valve (64) to connect an interior region of the workpiece (5) to an ambient pressure.

51. The apparatus according to any one of Claims 29 to 50, **characterised in that** a furcation (55) is connected to a chamber exhaust valve (61) to connect an interior region of the plasma chamber (17) to an ambient pressure.

52. The apparatus according to any one of Claims 29 to 51, **characterised in that** at least one furcation (55) is connected to a primary process gas valve (66).

53. The apparatus according to any one of Claims 29 to 52, **characterised in that** at least one furcation (55) is connected to a secondary process gas valve (67).

54. The apparatus according to any one of Claims 29 to 53, **characterised in that** at least one furcation (55) is connected to a process vacuum valve (62).

55. The apparatus according to any one of Claims 29 to 54, **characterised in that** at least one furcation (55) is connected to a chamber vacuum valve (63).

56. The apparatus according to any one of Claims 29 to 55, **characterised in that** at least one furcation (55) is arranged below the chamber bottom (29) in a vertical direction.

57. The apparatus according to any one of Claims 29 to 56, **characterised in that** at least one furcation (55) forms a common component with the chamber base (30).

58. The apparatus according to any one of Claims 29 to 57, **characterised in that** at least two of the valves (59) are arranged in the vicinity of a common valve block.

59. The apparatus according to any one of Claims 29 to 58, **characterised in that** at least one of the furcations (55) is arranged in the vicinity of the valve block.

60. The apparatus according to Claim 58 or 59, **characterised in that** the valve block having the at least two valves (59) and the at least one furcation (55) is arranged below the chamber base (30) in a vertical direction.

61. The apparatus according to any one of Claims 29 to 60, **characterised in that** the valve block forms a common component with at least one furcation (55).

62. The apparatus according to any one of Claims 29 to 61, **characterised in that** at least one of the valves (59) is formed as an electromagnetically controlled valve.

## Revendications

1. Procédé de traitement au plasma de pièces d'oeuvre (5) dans le cadre duquel la pièce d'oeuvre (5) est introduite dans une chambre (17) d'une station de traitement, laquelle chambre peut, en partie au moins, être évacuée, et dans le cadre duquel la pièce d'oeuvre (5) est positionnée par un élément de maintien (46) à l'intérieur de la station de traitement, et dans le cadre duquel un flux d'agent est scindé au moins une fois par un embranchement (55) en au moins deux flux partiels pour alimenter simultanément au moins deux chambres avec au moins un agent, et dans le cadre duquel un espace intérieur d'une pièce d'oeuvre (5) creuse est traité, la ou les station(s) de plasma (3) étant déplacée d'un positionnement d'introduction en un positionnement de sortie par une roue de traitement au plasma (2) en rotation, une première dépression étant appliquée par une vanne d'évacuation primaire (60) et une seconde dépression inférieure à la première étant appliquée par une vanne d'évacuation secondaire (61) et l'embranchement (55) étant agencé dans le socle (30) de la chambre, **caractérisé en ce que,** pour l'introduction et l'extraction de la pièce d'oeuvre (5), une paroi (18) en forme de manchon est relevée puis à nouveau abaissée.

2. Procédé selon la revendication 1, **caractérisé en ce que** l'embranchement (55) est réalisé en sens vertical.

3. Procédé selon la revendication 1, **caractérisé en ce que** l'embranchement (55) est réalisé en sens horizontal.

4. Procédé selon l'une des revendications 1 à 3, **caractérisé en ce qu'**une évacuation d'une cavité (4) de la station de plasma (3) a lieu à travers le fond (29) de la chambre.

5. Procédé selon l'une des revendications 1 à 4, **caractérisé en ce qu**'un gaz de procédé est introduit par le fond (29) de la chambre.

6. Procédé selon l'une des revendications 1 à 5, **caractérisé en ce que** le gaz de procédé est introduit par une lance (36) dans un espace intérieur de la pièce d'oeuvre (5).

7. Procédé selon l'une des revendications 1 à 6, **caractérisé en ce qu**'un agent au moins est introduit par au moins un embranchement (55) directement dans au moins deux chambres.

8. Procédé selon l'une des revendications 1 à 6, **caractérisé en ce qu'**un agent au moins est introduit par au moins un embranchement (55) dans les espaces intérieurs d'au moins deux pièces d'oeuvre (5).

9. Procédé selon l'une des revendications 1 à 6, **caractérisé en ce qu'**un agent au moins est introduit par au moins un embranchement (55) dans au moins deux lances (36).

10. Procédé selon l'une des revendications 1 à 9, **caractérisé en ce que** l'embranchement (55) assure la répartition d'une dépression.

11. Procédé selon l'une des revendications 1 à 9, **caractérisé en ce que** l'embranchement (55) assure la distribution d'un gaz de procédé.

12. Procédé selon l'une des revendications 1 à 9, **caractérisé en ce que** l'embranchement (55) assure la distribution d'une ventilation.

13. Procédé selon l'une des revendications 1 à 12, **caractérisé en ce que** des micro-ondes produites par un générateur de micro-ondes (19) sont introduites dans la cavité (4) au niveau du couvercle (31) de la chambre.

14. Procédé selon l'une des revendications 1 à 13, **caractérisé en ce qu**'est traitée une pièce d'oeuvre (5) en matière plastique thermoplastique.

15. Procédé selon l'une des revendications 1 à 14, **caractérisé en ce que** la pièce d'oeuvre (5) traitée est un récipient.

16. Procédé selon l'une des revendications 1 à 15, **caractérisé en ce que** la pièce d'oeuvre (5) traitée est une bouteille pour boissons.

17. Procédé selon l'une des revendications 1 à 16, **caractérisé en ce que** plusieurs cavités (4) sont mises à disposition par une station de plasma (3).

18. Procédé selon l'une des revendications 1 à 17, **caractérisé en ce qu**'un embranchement assure la distribution de micro-ondes.

19. Procédé selon l'une des revendications 1 à 18, **caractérisé en ce que** le traitement au plasma est réalisé sous forme de revêtement par plasma.

20. Procédé selon l'une des revendications 1 à 19, **caractérisé en ce que** le traitement au plasma fait appel à un plasma basse pression.

21. Procédé selon l'une des revendications 1 à 20, **caractérisé en ce que** l'on effectue une polymérisation par plasma.

22. Procédé selon l'une des revendications 1 à 21, **caractérisé en ce que** le plasma dépose en partie au moins des substances organiques.

23. Procédé selon l'une des revendications 1 à 21, **caractérisé en ce que** le plasma dépose en partie au moins des substances anorganiques.

24. Procédé selon l'une des revendications 1 à 23, **caractérisé en ce que** le plasma dépose une substance améliorant les propriétés de barrière de la pièce d'oeuvre (5).

25. Procédé selon la revendication 24, **caractérisé en ce qu**'est en outre déposé un agent de pontage pour améliorer l'adhésion de la substance à la surface de la pièce d'oeuvre (5).

26. Procédé selon l'une des revendications 1 à 25, **caractérisé en ce que** deux pièces d'oeuvre (5) au moins sont traitées simultanément dans une cavité commune.

27. Procédé selon l'une des revendications 1 à 18, **caractérisé en ce que** le traitement au plasma appliqué est une stérilisation par plasma.

28. Procédé selon l'une des revendications 1 à 18, **caractérisé en ce que** le traitement au plasma appliqué est une activation de surface de la pièce d'oeuvre (5).

29. Dispositif de traitement au plasma de pièces d'oeuvre (5) présentant, pour recevoir ces pièces (5), au moins une chambre à plasma (17) pouvant être évacuée agencée dans la zone d'une station de traitement, cette chambre à plasma (17) étant délimitée par un fond de chambre (29), un couvercle de chambre (31) ainsi qu'une paroi latérale (18) et munie d'au moins un élément de maintien (46) assurant le positionnement de la pièce d'oeuvre (5), et dans lequel deux chambres à plasma (17) au moins sont branchées sur au moins un embranchement (55) qui scinde un flux d'agent en au moins deux flux partiels, et dont la station de plasma (3) est conçue pour appliquer un revêtement dans l'espace intérieur d'une pièce d'oeuvre (5) creuse, la ou les station(s) de plasma (3) étant portée(s) par une roue de traitement au plasma (2) en rotation, un embranchement (55) au moins étant branché sur une vanne d'évacuation primaire (60) appliquant une première dépression et un embranchement (55) au moins étant branché sur une vanne d'évacuation secondaire (61) appliquant une seconde dépression inférieure à la première et un embranchement (55) au moins étant agencé dans le socle (30) de la station de plasma (3), **caractérisé en ce que** la paroi (18) de la chambre est réalisée en forme de manchon et agencée de façon à pouvoir être relevé et abaissé.

30. Dispositif selon la revendication 29, **caractérisé en ce que** l'embranchement (55) est orienté en sens vertical.

31. Dispositif selon la revendication 29, **caractérisé en ce que** l'embranchement (55) est orienté en sens horizontal.

32. Dispositif selon l'une des revendications 29 à 31, **caractérisé en ce qu**'un canal à vide au moins est aménagé dans le fond (29) de la chambre pour l'évacuation d'une cavité (4) de la station de plasma (3).

33. Dispositif selon l'une des revendications 29 à 32, **caractérisé en ce qu**'un canal au moins est aménagé dans le fond (29) de la chambre pour l'adduction d'un gaz de procédé.

34. Dispositif selon l'une des revendications 29 à 33, **caractérisé en ce qu**'une lance (36) pour l'adduction d'un gaz de procédé dans un espace intérieur de la pièce d'oeuvre (5) est agencée de façon à pouvoir être positionnée par rapport au fond (29) de la chambre.

35. Dispositif selon l'une des revendications 29 à 34, **caractérisé en ce qu**'un embranchement (55) au moins est directement branché sur les espaces intérieurs d'au moins deux chambres à plasma (17).

36. Dispositif selon l'une des revendications 29 à 35, **caractérisé en ce qu**'un embranchement (55) au moins est branché sur un canal de couplage (54) assurant la jonction de deux espaces intérieurs d'au moins deux pièces d'oeuvre (5).

37. Dispositif selon l'une des revendications 29 à 36, **caractérisé en ce qu**'un embranchement (55) au moins est branché sur au moins deux lances (36).

38. Dispositif selon l'une des revendications 29 à 37, **caractérisé en ce qu**'un embranchement (55) au moins est branché sur au moins un dispositif d'application d'une dépression.

39. Dispositif selon l'une des revendications 29 à 37, **caractérisé en ce qu**'un embranchement (55) au moins est branché sur au moins une alimentation en gaz de procédé.

40. Dispositif selon l'une des revendications 29 à 37, **caractérisé en ce qu**'un embranchement (55) au moins est branché sur au moins un système de ventilation.

41. Dispositif selon l'une des revendications 29 à 40, **caractérisé en ce qu**'un générateur de micro-ondes (19) est placé au niveau du couvercle (31) de la chambre.

42. Dispositif selon l'une des revendications 29 à 41, **caractérisé en ce que** la station de plasma (3) est conçue pour appliquer un revêtement d'une matière plastique thermoplastique à l'intérieur d'une pièce d'oeuvre (5).

43. Dispositif selon l'une des revendications 29 à 42, **caractérisé en ce que** la station de plasma (3) est conçue pour appliquer un revêtement à l'intérieur d'une pièce d'oeuvre (5) en forme de récipient.

44. Dispositif selon l'une des revendications 29 à 43, **caractérisé en ce que** la station de plasma (3) est conçue pour appliquer un revêtement à l'intérieur d'une pièce d'oeuvre (5) en forme de bouteille pour boissons.

45. Dispositif selon l'une des revendications 29 à 44, **caractérisé en ce que** plusieurs cavités (4) sont agencées dans la zone de la station de plasma (3).

46. Dispositif selon l'une des revendications 29 à 45, **caractérisé en ce qu**'une paroi (18) prévue pour mettre à disposition au moins deux cavités (4) est agencée de façon à pouvoir être positionnée.

47. Dispositif selon l'une des revendications 29 à 46, **caractérisé en ce qu'**un embranchement (55) au moins est branché sur au moins un générateur de micro-ondes (19).

48. Dispositif selon la revendication 29, **caractérisé en ce que** la vanne d'évacuation primaire (60) assure au moins temporairement le branchement aussi bien d'un espace intérieur de la pièce (5) qu'un autre espace intérieur de la chambre à plasma (17) sur un système commun de production d'une dépression.

49. Dispositif selon l'une des revendications 29 à 48, **caractérisé en ce que** la vanne d'évacuation secondaire (61) raccorde au moins temporairement exclusivement un espace intérieur de la pièce (5) à la source de dépression.

50. Dispositif selon l'une des revendications 29 à 49, **caractérisé en ce qu'**un embranchement (55) au moins est branché sur une vanne de purge (64) de la pièce assurant la communication entre un espace intérieur de la pièce (5) avec une pression ambiante.

51. Dispositif selon l'une des revendications 29 à 50, **caractérisé en ce qu'**un embranchement (55) au moins est branché sur une vanne de purge (61) de la chambre assurant la communication entre un espace intérieur de la chambre à plasma (17) avec une pression ambiante.

52. Dispositif selon l'une des revendications 29 à 51, **caractérisé en ce qu'**un embranchement (55) au moins est branché sur une vanne primaire de gaz de processus (66).

53. Dispositif selon l'une des revendications 29 à 52, **caractérisé en ce qu'**un embranchement (55) au moins est branché sur une vanne secondaire de gaz de processus (67).

54. Dispositif selon l'une des revendications 29 à 53, **caractérisé en ce qu'**un embranchement (55) au moins est branché sur une vanne d'évacuation opérationnelle (62).

55. Dispositif selon l'une des revendications 29 à 54, **caractérisé en ce qu'**un embranchement (55) au moins est branché sur une vanne d'évacuation de chambre (63).

56. Dispositif selon l'une des revendications 29 à 55, **caractérisé en ce qu'**un embranchement (55) au moins est agencé perpendiculairement sous le fond (29) de la chambre.

57. Dispositif selon l'une des revendications 29 à 56, **caractérisé en ce qu'**un embranchement (55) au moins forme un élément de construction commun avec le socle de la chambre (30).

58. Dispositif selon l'une des revendications 29 à 57, **caractérisé en ce qu'**au moins deux des vannes (59) sont agencées dans la zone d'un bloc de vannes commun.

59. Dispositif selon l'une des revendications 29 à 58, **caractérisé en ce que** l'un au moins des embranchements (55) est agencé dans la zone du bloc de vannes.

60. Dispositif selon la revendication 58 ou 59, **caractérisé en ce que** le bloc de vannes avec les deux vannes (59) au moins et un embranchement (55) au moins est agencé perpendiculairement sous le socle (30) de la chambre.

61. Dispositif selon l'une des revendications 29 à 60, **caractérisé en ce que** le bloc de vannes forme un élément de construction commun avec au moins un embranchement (55).

62. Dispositif selon l'une des revendications 29 à 61, **caractérisé en ce que** l'une au moins des vannes (59) est réalisée sous forme de vanne à commande électromagnétique.
